(19) Europäisches Patentamt
European Patent Office
Office européen des brevets

(11) **EP 1 693 679 B1**

(12) **EUROPÄISCHE PATENTSCHRIFT**

(45) Veröffentlichungstag und Bekanntmachung des Hinweises auf die Patenterteilung:
**11.06.2014 Patentblatt 2014/24**

(51) Int Cl.:
*H02H 3/00* (2006.01)          *H02H 9/08* (2006.01)
*G01R 27/16* (2006.01)

(21) Anmeldenummer: **05101276.3**

(22) Anmeldetag: **21.02.2005**

(54) **Verfahren zur Bestimmung eines Parameters eines elektrischen Versorgungsnetzes**

Method for the determination of a parameter of an electric power supply network

Procédé pour la détermination d'un paramètre dans un réseau d'alimentation électrique

(84) Benannte Vertragsstaaten:
**AT BE BG CH CY CZ DE DK EE ES FI FR GB GR HU IE IS IT LI LT LU MC NL PL PT RO SE SI SK TR**

(43) Veröffentlichungstag der Anmeldung:
**23.08.2006 Patentblatt 2006/34**

(73) Patentinhaber: **Adaptive Regelsysteme GmbH**
**5020 Salzburg (AT)**

(72) Erfinder: **Leikermoser, Albert**
**5020, Salzburg (AT)**

(74) Vertreter: **Weiss, Christian et al**
**Pinter & Weiss OG**
**Patentanwälte**
**Prinz-Eugen-Strasse 70**
**1040 Wien (AT)**

(56) Entgegenhaltungen:
EP-A- 0 235 145          EP-A- 0 595 677
EP-A1- 0 696 830          WO-A-02/15355
WO-A-2004/003578          DE-A1- 10 006 443
DE-A1- 10 307 972          US-A- 5 587 662

• **Heinz Unbehauen: "Regelungstechnik I", 1989, Vieweg, Braunschweig/Wiesbaden ISBN: 3-528-53332-3 vol. 6, pages 48-50,**

EP 1 693 679 B1

**Beschreibung**

Die gegenständliche Erfindung betrifft ein Verfahren und eine zugehörige Vorrichtung zur Bestimmung mindestens eines Parameters des Nullsystems eines elektrischen Netzes, vorzugsweise mit induktiv oder über ohmschen Widerstand geerdetem oder isoliertem Sternpunkt, und/oder eines Parameters des Nullsystems eines Leitungsabschnittes bzw. Leitungsabzweiges davon, insbesondere die Nulladmittanz $Y_0$ bzw. $Y$, die Phasensumme der Leitwerte der ohmschen Ableitungen $G_0$ bzw. $g$, die Phasensumme der Ableitkapazitäten $C_0$ bzw. $C$ und/oder die Resonanzkreisfrequenz $\omega_{res}$ des Nullsystems des Netzes, wobei in den Netzsternpunkt oder in das Nullsystem des elektrischen Netzes zumindest zeitweise ein Injektionssignal eingespeist wird und mit dem Injektionssignal ein Frequenzspektrum eingespeist wird.

Wie aus der Literatur bekannt, führen mittel- bis niederohmige Erdfehler im sternpunktkompensierten Netz zu einem starken Anstieg der Amplitude des netzfrequenten Anteils der Verlagerungsspannung. Diese Tatsache wird üblicherweise dazu benützt, das Vorhandensein von Erdfehlern zu erkennen. Bei höher- bis hochohmigen Erdfehlern, im Bereich von einigen zehn Kiloohm aufwärts, wie sie zum Beispiel durch das Berühren einer Phasenleitung mit dem Ast eines Baumes entstehen können, liegen die Fehlerströme größenmäßig im Bereich der Unsymmetrieströme des Netzes. Dies kann dazu führen, dass die Amplitude des netzfrequenten Anteiles der Verlagerungsspannung beim Eintritt von derartig hochohmigen Erdfehlern sogar sinkt, anstatt, wie dies bei niederohmigeren Erdfehlern der Fall ist, anzusteigen. Zusätzlich ist auch festzustellen, dass übliche Fehlererkennungseinrichtungen in sternpunktkompensierten Netzen, wie z.B. ein Schutzrelais, aufgrund der Kleinheit der Messsignale bei hochohmigen Erdfehlern erfahrungsgemäß unsicher funktionieren, sodass in solchen Situationen auf diesem Wege keine zuverlässige Information über das Vorliegen eines Erdfehlers im Netz abgeleitet werden kann.

Ferner ist zu bedenken, dass der netzfrequente Anteil der Verlagerungsspannung allein schon wegen der schwankenden Unsymmetrieströme ebenfalls zeitlichen Änderungen unterliegt. Zusätzlich ist zu berücksichtigen, dass sich die ohmschen Ableitungen des Netzes aufgrund von klimatischen Veränderungen ebenfalls stark ändern können.

Also bedarf es neuer Methoden zur Erkennung der Fehlerhaftigkeit des sternpunktkompensierten Netzes speziell im Zusammenhang mit hochohmigen Erdfehlern.

Zur Reduktion der Fehlerströme beim Auftreten von Erdfehlern in elektrischen Verteilnetzen wird der Sternpunkt des Speisetransformators vorzugsweise induktiv geerdet, das Netz also sternpunktkompensiert betrieben. Die Induktivität dieser, zwischen dem Sternpunkt des Speisetransformators und dem Erdpotential angeordneten, Erdschlusslöschspule ist den unterschiedlichen Netzkonfigurationen jeweils nach einer Änderung der Netztopologie neu anzupassen (abzustimmen), wofür es eine Reihe von bekannten Verfahren gibt.

In der EP 235 145 B1 wird ein Verfahren zur Überwachung und Bestimmung des Dämpfungs-Unsymmetrie- und Verstimmungsgrades, also der für die Abstimmung der Erdschlusslöschspule notwendigen Parameter, beschrieben, bei dem in regelmäßigen Zeitabständen oder aufgrund einer Änderung der Sternpunkt-Erdspannung ein Reaktanzkomplement zwischen Sternpunkt und Erde geschaltet wird. Dabei wird die Sternpunkt-Erdspannung vor und nach dem Schalten des Reaktanzkomplementes in Betrag und Phase bezüglich einem Referenzsignal ermittelt und der durch die beiden Messwerte und dem Koordinatenursprung definierte Ortskreis der Sternpunkt-Erdspannung als Funktion der Verstimmung bestimmt. Daraus werden dann die obengenannten Parameter und somit auch die aktuelle Verstimmung der Erdschlusslöschspule und gegebenenfalls deren notwendige Korrektur berechnet. Im Fall einer stark verstimmten Erdschlusslöschspule kann die Sternpunkt-Erdspannung Une sowohl vor und auch nach der Zuschaltung des Reaktanzkomplements sehr kleine Werte annehmen, sodass deren Messung gewissen Ungenauigkeiten bzw. Messfehlern aufgrund von Fremdinduktionen auf den Messsignalleitungen oder Signalrauschen unterliegen kann. Aufgrund der numerischen Konditionierung des Verfahrens können sich dann bei der Durchführung erhebliche Fehlerverstärkungen bezüglich der Messfehler ergeben, die letztlich die Parameterbestimmung und den Abstimmvorgang der Erdschlusslöschspule maßgeblich beeinflussen können.

Eine weitere Methode zur Bestimmung von Abstimmung und Verstimmungsgrad der Kompensation eines elektrischen Versorgungsnetzes wird in der EP 595 677 A1 beschrieben. Bei diesem Verfahren wird ein netzfrequentes Hilfssignal ins Nullsystem des Netzes eingespeist und die Sternpunkt-Erdspannung vor und während der Einspeisung sowie der Injektionsstrom in Betrag und Phase bezüglich einem Referenzsignal gemessen. Aus den Messwerten der Änderung der Sternpunkt-Erdspannung und dem Injektionsstromsignal kann dann die Impedanz des Nullsystems des Gesamtnetzes und daraus die aktuelle Verstimmung sowie gegebenenfalls deren durchzuführende Korrektur ermittelt werden. Bei Netzzuständen mit einer stark verstimmten Erdschlusslöschspule kann die Sternpunkt-Erdspannung $U_{ne}$ bzw. deren Änderung aufgrund der Injektion ins Nullsystem auch bei der Anwendung dieser Methode sehr kleine Werte annehmen, sodass deren Messung gewissen Ungenauigkeiten bzw. Messfehlern aufgrund von Fremdinduktionen auf den Messsignalleitungen oder Signalrauschen unterliegen kann. Aufgrund der numerischen Konditionierung können auch bei der Durchführung dieses Verfahrens erhebliche Fehlerverstärkungen aufgrund der Messfehler auftreten, die letztlich die Parameterbestimmung und den Abstimmvorgang der Erdschlusslöschspule erheblich beeinflussen können. Durch die Erhöhung des Injektionsstromes kann die durch das Injektionssignal verursachte Änderung der Sternpunkt-Erdspannung vergrößert werden. Diese Maßnahme verbessert die numerische Konditionierung des Verfahrens. Sie wird jedoch durch technische und kommerzielle Kriterien in gewisser Weise begrenzt.

Aus der WO 2004/003578 A1 kann wiederum ein Verfahren entnommen werden, bei dem ein Hilfssignal mit einer Frequenz ungleich der Netzfrequenz in das Nullsystem des elektrischen Netzes eingespeist wird und mittels FFT Algorithmen aus dem Nullstrom und der Verlagerungsspannung bezüglich der Einspeisefrequenz Parameter des elektrischen Netzes ermittelt werden, die z.B. für die Abstimmung der Löschspule verwendet werden können. Die genaue Bestimmung der Spektralanteile mittels FFT Algorithmen benötigt jedoch zur Vermeidung von spektralen Leckeffekten einen stationären Systemzustand, der sich aufgrund des langsamen Einschwingens zufolge der geringen Netzdämpfung aber erst nach langen Wartezeiten einstellt. Außerdem ist zum Zeitpunkt der Injektion des Hilfssignals die Resonanzfrequenz noch nicht bekannt, wodurch unter Umständen Hilfssignale mit großen Signalamplituden notwendig wären, oder ein mehrfaches Wiederholen von Injektionszyklen mit unterschiedlichen Frequenzen notwendig wäre.

Aus der WO 02/15355 A2 ist ein Verfahren zur Erkennung und Ortung von Erdfehlern bekannt, bei dem ein Hilfssignal mit Netzfrequenz eingespeist wird, sodass die Verlagerungsspannung bei Netzfrequenz kompensiert wird. In diesem Zustand kann ein weiteres Hilfssignal mit einer Frequenz ungleich der Netzfrequenz eingespeist werden, und aus den gemessenen Größen bezüglich der Einspeisefrequenz Netzparameter bestimmt werden. Es ist auch beschrieben, mehrere Hilfssignale mit unterschiedlichen Frequenzen ungleich der Netzfrequenz einzuspeisen und aus den daraus ermittelten Netzparametern eine bestmögliche Approximation der Netzparameter, z.B. durch Mittelwertbildung, zu bestimmen.

Aus der US 5,587,662 A geht ein Verfahren hervor, bei dem ein Leitungsparameter in Form der Leitungsimpedanz ermittelt wird, indem ein Hilfssignal mit einer Frequenz ungleich der Netzfrequenz in die Leitung eingespeist wird und Spannung und Strom bezüglich dieser Frequenz gemessen und zur Bestimmung der Leitungsparameter dividiert werden. Dabei können sukzessive auch eine Fülle verschiedener Frequenzen in die Leitung eingespeist werden. Die DE 100 06 443 A1 beschreibt, dass zur Bestimmung der Leitungsimpedanz ein ganzes Frequenzspektrum eingespeist wird.

Die der Erfindung zugrundeliegende Aufgabe ist es daher, ein einfach umsetzbares Verfahren zu entwickeln, das selbst im Fall von Netzzuständen mit stark verstimmter Erdschlusslöschspule und/oder bei hochohmigen Erdfehlern mit geringen Injektionssignalamplituden starke Signaländerungen im Nullsystem bewirkt und damit die numerisch Stabilität und Robustheit der Parameterbestimmung und somit auch des Abstimmvorganges der Erdschlusslöschspule bzw. der Erkennung von Erdfehlern deutlich erhöht werden kann.

Diese Aufgabe wird durch das Verfahren gemäß Anspruch 1 gelöst. Dabei wird mit dem Injektionssignal ein Frequenzspektrum eingespeist, wobei das Frequenzspektrum des Injektionssignals den Bereich zwischen einer wählbaren minimalen Frequenz $f_{min}$ und einer wählbaren maximalen Frequenz $f_{max}$ im Wesentlichen lückenlos abdeckt und zumindest ein Parameter aus einem das gesamte Frequenzspektrum berücksichtigenden funktionalen Zusammenhang von zumindest einer der zwei messbaren Größen Nullstrom und Verlagerungsspannung bezüglich des gesamten eingespeisten Frequenzspektrums durch ein Verfahren im Zeitbereich oder Frequenzbereich ermittelt wird. Dieses Verfahren bewertet die zugrunde liegenden Messgrößen damit nicht nur bezüglich einer einzigen diskreten Frequenz, oder einiger diskreter Frequenzen, sondern vorzugsweise bezüglich der Gesamtheit der Frequenzanteile des Injektionsspektrums, da die Parameter bezüglich des gesamten Frequenzspektrums bestimmt werden. Daraus resultiert eine Erhöhung der Robustheit und Reproduzierbarkeit bei der Parameterbestimmung, was letztendlich zu einer Verbesserung der Gesamtperformance der Regeleinrichtung führt.

Die Robustheit wird noch weiter erhöht, wenn sichergestellt wird, dass im eingespeisten Frequenzspektrum die Resonanzfrequenz $\omega_{res}$ des Nullsystems des elektrischen Netzes enthalten ist. Wird also ein Signal das die Resonanzfrequenz beinhaltet in geeigneter Weise in das Nullsystem des Gesamtnetzes eingespeist, so ergibt sich aufgrund der Anregung des Systems an einer Polstelle eine starke Erhöhung der Sternpunkt-Erdspannung $U_{ne}$ im Vergleich zur Anregung mit anderen von der Resonanzfrequenz unterschiedlichen Frequenzen. Dadurch können bei resonanzfrequenter Anregung auch mit kleinen Amplituden des Injektionssignals aufgrund der Polanregung hohe Signalamplituden der Sternpunkt-Erdspannung $U_{ne}$ und damit auch des durch die Löschspule zurückfließenden Nullstromes $i_0$ erzeugt werden, während die sich von der Resonanzfrequenz unterscheidenden Spektralanteile des Injektionssignals nur kleine Amplituden bezüglich der Sternpunkt-Erdspannung $U_{ne}$ und Nullstrom $i_0$ ergeben. Wegen der daraus entstehenden hohen Signalamplituden der Sternpunkt-Erdspannung $U_{ne}$ sowie des Nullstromes $i_0$ bezüglich ihrer resonanzfrequenten Signalanteile ergibt sich daraus eine gute numerische Konditionierung der anzuwendenden Verfahren zur Bestimmung der Netzparameter, was letztlich die Robustheit und numerische Stabilität des Abstimmverfahrens für die Erdschlusslöschspule, als auch von Verfahren zur Erkennung und Ortung von Erdfehlern, selbst bei stark verstimmten Netzzuständen und auch bei sehr hochohmigen Erdfehlern, im Vergleich zu anderen Methoden deutlich erhöht.

Das Frequenzspektrum kann entweder dadurch erzeugt werden, dass beispielsweise die Frequenz des Injektionssignals, vorzugsweise innerhalb einer bestimmten Injektionszeit, zwischen der minimalen Frequenz $f_{min}$ und der maximalen Frequenz $f_{max}$ variiert wird, vorzugsweise kontinuierlich oder diskret erhöht wird, oder indem, wie beansprucht, als Injektionssignal ein Signal gewählt wird, ein impulsförmiges Signal, das zwischen der minimalen Frequenz $f_{min}$ und

der maximalen Frequenz $f_{max}$ von Null verschiedene Spektralanteile beinhaltet, was eine besonders einfach unzusetzende Methode darstellt.

Werden die netzfrequenten Signalanteile und jene Signalanteile, deren Frequenz einem ungeradzahlig ganzzahligem Vielfachen der Netzfrequenz entspricht, aus dem Frequenzspektrum der verarbeiteten Messgrößen herausgefiltert, oder werden diese Anteile nicht eingespeist, oder werden diese Anteile durch Subtraktion der vor dem Start des Injektionsvorganges als Funktion der Zeit gemessenen und bezüglich der Netzperiode für die Zeiten nach dem Injektionsvorgang periodisch fortgesetzten Größen von den nach dem Start des Injektionsvorganges gemessenen Größen oder durch Subtraktion der Spektralanteile der periodisch fortgesetzten Größen von den Spektralanteilen der gemessenen Größen entfernt, ergeben sich bezüglich der nicht netzfrequenten Anteile einfache funktionale Zusammenhänge, wodurch die Ermittlung der Parameter vereinfacht wird.

Als besonders einfache Verfahren zur Bestimmung der Parameter lassen sich hinlänglich bekannte und in großer Anzahl existierende Parameterschätzverfahren anwenden, bei dem z.B. das elektrische Netz und/oder ein Leitungsabschnitt bzw. Leitungsabzweig durch ein mathematisches Modell beschrieben wird, bei dem die Modellausgangsgrößen $A_{Mod}$ als Funktion der messbaren Eingangsgrößen und der zu ermittelnden Parameter beschrieben wird und daraus eine Modellfehlerfunktion als Differenz aus gemessenen Ausgangsgrößen $A_P$ und den Modellausgangsgrößen $A_{Mod}$ und eine Verlustfunktion V, beispielsweise in Form der Summe der Quadrate der Modellfehlerfunktion im gewählten Beobachtungszeitraum, ermittelt wird, die zur Bestimmung der Parameter derart optimiert wird, dass die Verlustfunktion V minimal wird. Solche Verfahren lassen sich einfach in digitaler Form auf Computern realisieren und lassen sich auch einfach in Regelungseinheiten für die Abstimmung von Löschspulen oder zur Erkennung und Ortung von Erdfehlern oder Schalthandlungen im Netz integrieren.

Durch die Einbringung eines impulsartigen Injektionssignals wird die Ermittlung eines Parameters, insbesondere die Resonanzkreisfrequenz $\omega_{res}$ des Nullsystems des Netzes, wesentlich vereinfacht , wenn man berücksichtigt, dass das Injektionssignal $i_{inj}$ ab einem Zeitpunkt $t \geq t_1$ Null sein muss. Dabei lässt sich eine Modellfehlerfunktion bezüglich nur einer einzigen messbaren Größe, der Verlagerungsspannung $U_{ne}$ oder dem Nullstrom $i_0$, ermitteln, die zur Bestimmung des Parameters optimiert wird. Ferner kann durch Berechnung der Fouriertransformierten oder der DFT oder FFT für die zu den Zeitpunkten $t \geq t_1$ ermittelten Messwerte dieser Messgröße die Resonanzkreisfrequenz $\omega_{res}$ ebenfalls einfach bestimmt werden, da klar ist, dass deren Zeitsignal für die Zeitpunkte $t \geq t_1$ dem Ausschwingvorgang eines durch einen impulsartigen Vorgang angeregten Parallelschwingkreises, also einem exponentiell abklingenden sinusartigen Signal, entsprechen muss. Bei der Anwendung dieses Verfahrens werden nur Messwerte einer Größe benützt, die zu Zeitpunkten nach dem Ende des impulsartigen Injektionsvorganges gemessen werden, also zu Zeitpunkten, bei denen das Injektionssignal $i_{inj}$ bereits Null ist. Somit kann das Injektionssignal $i_{inj}$ die Messwerte der gemessenen Größe, also die Sternpunkt-Erdspannung $U_{ne}$ oder den Nullstrom $i_0$ zu diesen Zeitpunkten auch nicht verfälschen. Die Tatsache, dass nur eine Messgröße gemessen und verarbeitet werden muss, reduziert die Kosten zur Durchführung dieses Verfahrens erheblich.

Die so bestimmten Parameter des elektrischen Netzes bzw. eines Leitungsabschnittes bzw. - -abzweigs, insbesondere $Y_0$, Y, G, g, $C_0$, C oder $\omega_{res}$, lassen sich besonders vorteilhaft und einfach zur Erkennung und Ortung von Erdfehlern, Erkennung und Lokalisierung von Schalthandlungen im Netz und/oder zur Abstimmung einer Löschspule verwenden, wie z.B. auch in der WO 2004/003578 A1 des Anmelders beschrieben.

Mit den derart bestimmten Parametern des Netzes kann die notwendige Erdschlusslöschspuleninduktivität $L_{soll}$, gegebenenfalls unter Berücksichtung einer vom Anwender vorgegebenen Verstimmung, als Funktion der ermittelten Parameter des Nullsystems des elektrischen Netzes zur Einhaltung der Resonanzbedingung ermittelt werden und durch Vergleich mit einer momentan gegebenen Erdschlusslöschspuleninduktivität $L_{ist}$ oder durch Vergleich der ermittelten Resonanzkreisfrequenz $\omega_{res}$ mit der gewünschten Resonanzkreisfrequenz $\omega$ soll einfach festgestellt werden, ob eine Neuabstimmung der Erdschlusslöschspule notwendig ist oder nicht. Die tatsächliche Abstimmung kann mit hinlänglich bekannten Methoden zur Abstimmung einer Erdschlusslöschspule durchgeführt werden.

Falls die Verlagerungsspannung $U_{ne}$ als Messgröße nicht oder nicht in ausreichender Genauigkeit zugänglich ist, kann ein Parameter des Netzes immer noch ermittelt werden, wenn mittels eines mathematischen Modells des elektrischen Netzes ein funktionaler Zusammenhang zwischen dem gemessenen Nullstrom $i_0$ des elektrischen Netzes, dem Injektionssignal und zumindest einem Parameter des Netzes hergestellt wird und daraus der oder die Parameter bestimmt werden. Das tatsächlich eingespeiste Injektionssignal ist messbar und es kann durch einen einfachen Zusammenhang, der im Wesentlichen nur von der Art der Einbringung des Injektionssignals ins Nullsystem des Netzes abhängig ist, auf das im mathematischen Modell verwendete Injektionsstromsignal rückgeschlossen werden. Durch diesen neuartigen Ansatz ist es möglich, Verfahren zur Bestimmung der Parameter eines elektrischen Netzes auch dann anzuwenden, selbst wenn die Verlagerungsspannung nicht oder nicht in ausreichender Genauigkeit bekannt oder messbar ist.

Die Erfindung wird anhand der folgenden Erläuterungen unter Bezugnahme auf die begleitenden beispielhaften und schematischen Zeichnungen Fig. 1 bis 4 näher beschrieben. In den Zeichnungen zeigt

Fig. 1 ein elektrisches Ersatzschaltbild eines sternpunktkompensierten Netzes mit einem Leitungsabschnitt bzw.

Leitungsabzweig,
Fig. 2 ein vereinfachtes elektrisches Ersatzschaltbild des Nullsystems eines sternpunktkompensierten Netzes mit induktiver Sternpunkterdung,
Fig. 3 ein elektrisches Ersatzschaltbild des Nullsystems für die Erdschlusslöschspule, der Injektionseinheit und des Netzes und
Fig. 4 ein Ablaufschema zur Bestimmung der Netzparameter.

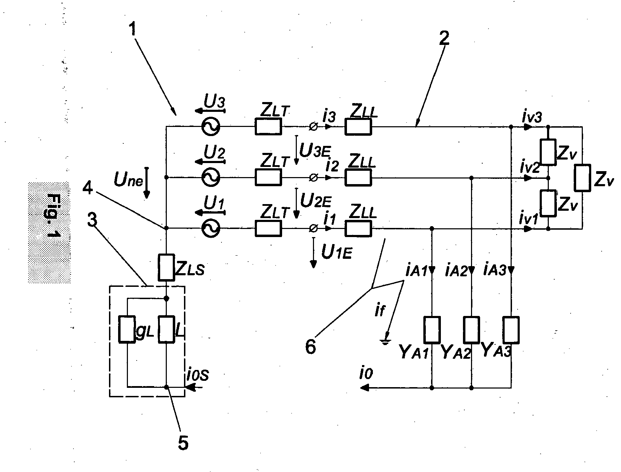

In Fig. 1 ist das bekannte elektrische Ersatzschaltbild eines Leitungsabschnittes 2 eines elektrischen Versorgungsnetzes 1 dargestellt. Zwischen dem Transformatorsternpunkt 4 und dem Erdungspunkt 5 befindet sich beispielhaft eine Löschspule 3, die durch einen ohmschen Leitwert $g_L$ und einer Induktivität L beschrieben wird. Wird das Netz widerstandsgeerdet betrieben, so wird der Erdungswiderstand durch den Leitwert $g_L$ repräsentiert, während die Induktivität L entfällt. Die Streuinduktivitäten sowie die ohmschen Widerstände der Sekundärwicklung des Speisetransformators werden durch die für alle drei Phasen als gleich groß angenommenen Längsimpedanzen $Z_{LT}$ repräsentiert. In das Netz, hier bestehend aus nur einem Leitungsabschnitt 2, werden die Phasenspannungen $U_1$, $U_2$ und $U_3$ eingespeist und es fließen die Phasenströme $i_1$, $i_2$ und $i_3$. Zwischen den drei Phasen und der Erde liegen die Phasen-Erdspannungen $U_{1E}$, $U_{2E}$ und $U_{3E}$ an.
Ein Leitungsabschnitt 2 wird, wie für den betrachteten Frequenzbereich von <150Hz zulässig, durch Leitungslängsimpedanzen $Z_{LL}$, bestehend aus einem ohmschen und einem induktiven Term, und Leitungsableitadmittanzen (bzw. Phasen-Erdadmittanzen) $Y_{A1}$, $Y_{A2}$ und $Y_{A3}$, bestehend aus einer ohmschen g und einer dazu parallelen kapazitiven Komponente C, beschrieben. Über die Leitungsableitadmittanzen $Y_{A1}$, $Y_{A2}$ und $Y_{A3}$ fließen die Ableitströme $i_{A1}$, $i_{A2}$ und $i_{A3}$. Die Ableitströme $i_{A1}$, $i_{A2}$ und $i_{A3}$ fließen als Nullstrom $i_0$ dieses Leitungsabschnittes über die Löschspule 3 zum Transformatorsternpunkt 4 zurück. Am Erdungspunkt der Löschspule 3 vereinigen sich die Nullströme $i_0$ aller vorhandenen Leitungsabschnitte 2 zur Summe der Nullströme $i_{0S}$. Verbraucherseitig, repräsentiert durch Verbraucherimpedanzen $Z_V$, fließen die Verbraucherströme $i_{V1}$, $i_{V2}$ und $i_{V3}$.

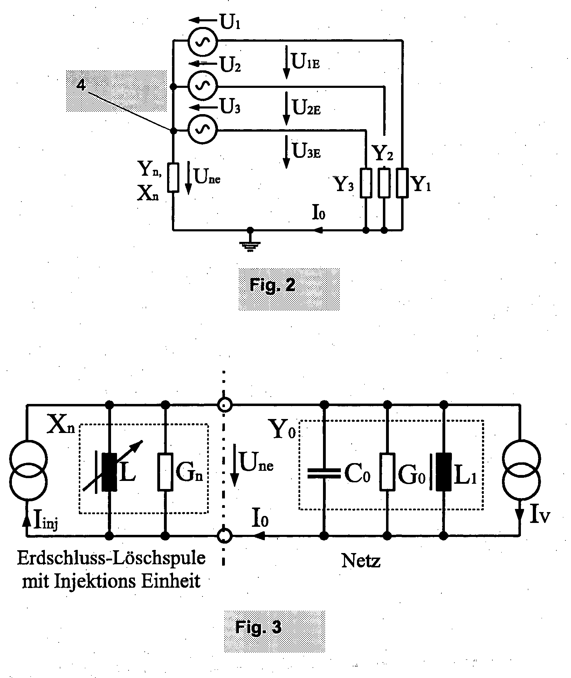

Um die Wirkungsweise und die Vorteile der Injektion eines Frequenzspektrums ins Nullsystem des Netzes darlegen zu können, werden einige Zusammenhänge für ein vereinfachtes Modell eines sternpunktkompensierten Netzes, wie in Fig. 2 dargestellt, hergeleitet. Dabei bleiben die Leitungslängsimpedanzen $Z_{LL}$, die Streuimpedanzen des Transformators $Z_{LT}$, die von den Nullströmen durchflossenen Erdimpedanzen und die Leitungskoppelkapazitäten zwischen den einzelnen Phasen aus Gründen der Übersichtlichkeit und ihres geringen Einflusses im Nullsystem unberücksichtigt. Sie können jedoch ohne Beeinträchtigung der Methodik dieses Verfahrens mit berücksichtigt werden. Dies führt lediglich zu einer Erhöhung der Ordnung der Modellgleichungen. Da eventuell im Netz vorhandene zusätzliche Erdschlusslöschspulen nur im Nullsystem eine Auswirkung zeigen, werden diese erst später bei den Gleichungen für die Zusammenhänge im Nullsystem des Gesamtnetzes eingeführt. Dieses Ersatzschaltbild wird zur Herleitung von für das erfindungsgemäße Verfahren wichtigen Beziehungen verwendet.

Zu den folgenden Erläuterungen sei vorab angemerkt, dass sich die nachfolgenden Formeln, wenn nicht anders angemerkt, auf die Laplacetransformierten der jeweiligen elektrischen Größen beziehen, die vorkommenden elektrischen Größen zwecks Vereinfachung der Schreibweise jedoch nicht explizit als Funktion der komplexen Frequenzvariablen $s$ geschrieben werden, also wird beispielsweise $U_{ne}(s)$ mit $U_{ne}$ bezeichnet.

Die Phasen-Erdadmittanzen $Y_1$, $Y_2$, $Y_3$ einzelner Leitungsabschnitte bzw. -abzweige lassen sich für den betrachteten Frequenzbereich bis ca. 150 Hz in guter Näherung durch die Parallelschaltung einer Abschnittkapazität mit einem Abschnittableitwiderstand beschreiben. Die drei Phasen-Erdadmittanzen $Y_1$, $Y_2$, $Y_3$ des Gesamtnetzes ergeben sich durch Nichtberücksichtigung der Leitungslängsimpedanzen als Parallelschaltung der einzelnen Leitungsabschnitte und somit durch phasenbezogene Summation obiger Abschnittsadmittanzen über alle Teilabschnitte bzw. -abzweige des Gesamtnetzes. Wenn man berücksichtigt, dass sich die drei Phasen-Erdspannungen $U_{1E}$, $U_{2E}$ und $U_{3E}$ durch Summation der zugehörigen Phasenspannungen $U_1$, $U_2$ und $U_3$ mit der Sternpunkt-Erdspannung (oder Verlagerungsspannung) $U_{ne}$ ergeben und ferner bedenkt, dass die Summe der drei Phasenspannungen $\Delta$ U zwar theoretisch null sein muss, in der Praxis aber aufgrund nicht perfekter magnetischer Verkoppelungen der Transformatorwicklungen im Zusammenhang mit Laststromeinflüssen und/oder durch Fehlen einer Dreieckswicklung im Transformator einen manchmal nicht unerheblichen Wert annehmen kann, ergibt sich unter Berücksichtigung der angeführten Definitionen für den, über das Erdreich und die Erdschlusslöschspule 3 in den Sternpunkt 4 zurück fließenden, Nullstrom $i_0$ als Funktion der Sternpunkt-Erdspannung $U_{ne}$ nach kurzer Herleitung der bekannte Zusammenhang:

$$i_0 = U_{ne} \cdot Y_0 + i_v + \left[ i_f \right],$$

mit der Nulladmittanz, bzw. gleichwertig auch als Erdadmittanz bezeichnet, $Y_0 = (Y_1 + Y_2 + Y_3)$ und dem Unsymmetriestrom,

bzw. Verlagerungsstrom, $i_v = \Delta U \cdot \overline{Y} + \sum_{n=1}^{3} U_n \cdot \Delta Y_n$, mit der A-symmetrie der Phasenspannungen $\Delta U = U_1 + U_2 +$ $U_3$, dem Mittelwert der drei Phasen-Erdadmittanzen $\overline{Y} = Y_0/3$ und der Abweichung der Phasen-Erdadmittanzen der Phase (n) vom Mittelwert $\Delta Y_n = Y_n - \overline{Y}$, und gegebenenfalls dem im Fehlerfall vorhandenen Fehlerstrom $i_f$.

Der Term $Y_0$ repräsentiert die Phasensumme der Ableitadmittanzen $Y_0=(Y_1+Y_2+Y_3)$ der drei Phasen, wobei sich die einzelnen Ableitadmittanzen aus der Parallelschaltung eines resistiven g und eines kapazitiven Termes C zusammensetzen. Für den (n)-ten Leitungsabschnitt bzw. -abzweig wird die Nulladmittanz $Y_0$ mit Y(n) bezeichnet.

Die obige Gleichung für den Nullstrom $i_0$ liefert die wichtige Erkenntnis, dass sich der Nullstrom $i_0$ des Gesamtnetzes aus der Summe von einem, vom Produkt der Sternpunkt-Erdspannung $U_{ne}$ mit der Nulladmittanz $Y_0$ abhängigen Term und dem Unsymmetriestrom $i_v$ ergibt. Dieser Unsymmetriestrom hängt wiederum einerseits von der Asymmetrie der Phasenspannungen $\Delta U$ sowie von den Unsymmetrien der drei Phasen-Erdadmittanzen $\Delta Y_n$ ab, ist jedoch unabhängig vom Nullsystem und somit von der Sternpunkt-Erdspannung $U_{ne}$ und kann daher in einem Ersatzschaltbild für das Nullsystem durch eine Stromquelle repräsentiert werden.

Betrachtet man nun die obige Beziehung für den Unsymmetriestrom $i_v$ spektral, also $i_v(\overline{j\omega})$, so kann aufgrund der Fourierreihenzerlegung der Phasenspannungen und der Erkenntnis, dass sich der Unsymmetriestrom $i_v(\overline{j\omega})$ als Linearkombination der drei Phasenspannungen ergibt, direkt daraus gefolgert werden, dass der Spektralanteil des Unsymmetriestromes $i_v(\overline{j\omega})$ in Analogie zu den drei Phasenspannungen für Kreisfrequenzen ungleich der Netzkreisfrequenz $\omega_N$ und deren ganzzahlig ungeradzahligen Vielfachen Null sein muss, im elektrischen Ersatzschaltbild des Nullsystems nach Fig.3 also unberücksichtigt bleiben kann und daher für diese Kreisfrequenzen die Stromquelle des Unsymmetriestromes $i_v(\overline{j\omega})$ aus dem Ersatzschaltbild zu eliminieren ist. Daher werden die Spektralanteile der Sternpunkt-Erdspannung $U_{ne}(\overline{j\omega})$ und des Nullstromes $i_0(\overline{j\omega})$ bezüglich dieser Kreisfrequenzen ausschließlich von der Injektionsstromquelle verursacht.

Werden nun die netzfrequenten Grundwellenanteile sowie jene Oberwellenanteile, deren Frequenzen einem ganzzahlig ungeradzahligem Vielfachen der Netzfrequenz entsprechen, mit analogen Filtern aus den Messgrößen von $U_{ne}(t)$, $i_{inj}(t)$ und $i_0(t)$, oder in digitaler Weise aus den abgetasteten und digitalisierten Messgrößen von $U_{ne}(t)$, $i_{inj}(t)$ und $i_0(t)$, durch Verwendung geeigneter Sperrfilter, also Filtern, die genau obige Frequenzanteile aus den genannten Signalen herausfiltern, vorgefiltert, so ergibt sich unter der Voraussetzung, dass diese Filterung kontinuierlich durchgeführt wird oder mit der Injektion erst lange nach dem Einschwingen der Sperrfilterkette begonnen wird, der folgende Zusammenhang (der Index F bezeichnet im Nachfolgenden derart gefilterte Größen)

$$i_0^F(s) - U_{ne}^F(s).Y_0(s) = 0,$$

$$Y_0(s) = G_0 + s.C_0 + \frac{1}{s.L_1}$$

mit der Laplace-Transformierten des gefilterten Nullstromsignals $i_0^F(s)$ und der Laplace-Transformierten der Netznulladmittanz $Y_0(s)$ mit zusätzlicher Erdschlusslöschspule $L_1$.

Diese Sperrfilter besitzen jedoch die unangenehme Eigenschaft, dass speziell bei exakter Abstimmung der Erdschlusslöschspule, also bei weitgehend der Netzfrequenz entsprechenden Resonanzfrequenzen des kompensierten Netzes, gerade diese starke, ungefähr netzfrequente, Signalanregung in den auszuwertenden Messgrößen aufgrund der Filtercharakteristik (Unterdrückung netzfrequenter Signalanteile) wieder unterdrückt wird. Betrachtet man das Ersatzschaltbild für den Injektionsvorgang nach Fig. 3, dann ist klar ersichtlich, dass die Schaltung von zwei Stromquellen, nämlich $i_{inj}(t)$ und $i_v(t)$, gespeist wird. Da die Schaltungselemente als linear angenommen werden können, kann in bekannter Weise das Superpositionsprinzip zur Anwendung gebracht werden. Das bedeutet, dass sich die Sternpunkt-Erdspannung $U_{ne}(t)$ als Summe des vom Unsymmetriestrom $i_v(t)$ verursachten Signalanteiles und des vom Injektionsstrom $i_{inj}(t)$ verursachten Signalanteiles darstellen lässt.

Der vom Unsymmetriestrom $i_v(t)$ verursachte Signalanteil an der Sternpunkt-Erdspannung $U_{ne}(t)$ kann aber vor dem Start des Injektionsvorganges als Funktion der Zeit gemessen und aufgrund seiner oben genannten Eigenschaften für die Zeitpunkte nach dem Injektionsstart bezogen auf die Netzfrequenz periodisch fortgesetzt werden, da er nur einen netzfrequenten Anteil und bezüglich der Netzfrequenz ganzzahlig ungeradzahlige Vielfache als Oberwellenanteile enthalten kann und sich während der kurzen Injektionszeit kaum ändert. Subtrahiert man nun für die Zeitpunkte nach dem Injektionsbeginn bei t=0 von der gemessenen Sternpunkt-Erdspannung $U_{ne}(t)$ den vor dem Start des Injektionsvorganges als Funktion der Zeit, also für t<0, gemessenen und bezüglich der Netzperiode für die Zeiten t≥0 periodisch fortgesetzten Signalanteil der Sternpunkt-Erdspannung $U_{ne}(t)$, so erhält man aufgrund des Überlagerungsprinzips direkt einsichtig den vom Injektionsstrom $i_{inj}(t)$ verursachten Signalanteil an der Sternpunkt-Erdspannung $U_{ne}(t)$. Dieser wird aus Gründen der Übersichtlichkeit und der Gleichwertigkeit mit der Filtermethode wieder mit $U_{ne}^{F}(t)$ bezeichnet.

In ganz analoger Weise kann für den Nullstrom $i_0(t)$ vorgegangen werden. Subtrahiert man für die Zeitpunkte nach dem Injektionsbeginn bei t=0 vom gemessenen Nullstrom $i_0(t)$ den vor dem Start des Injektionsvorganges als Funktion der Zeit, also für t<0, gemessenen und bezüglich der Netzperiode für die Zeiten t≥0 periodisch fortgesetzten Signalanteil des Nullstromes $i_0(t)$, so erhält man aufgrund des Überlagerungsprinzips den vom Injektionsstrom $i_{inj}(t)$ verursachten Signalanteil am Nullstrom $i_0(t)$. Dieser wird aus Gründen der Übersichtlichkeit und der Gleichwertigkeit mit der Filtermethode wieder mit $I_{0}^{F}(t)$ bezeichnet.

Damit hat man eine Alternative zur oben beschriebenen Filterung der Messgrößen durch Sperrfilter, die die erwähnte unangenehme Eigenschaft nicht aufweist. Aufgrund der Gleichwertigkeit der dargestellten Überlagerungsmethode mit der Sperrfiltermethode wird im folgenden Text nicht mehr unterschieden, auf welche Weise die so genannten "gefilterten" Größen $I_{0}^{F}(t)$ und $U_{ne}^{F}(t)$ erzeugt werden.

Für das gefilterte Injektionsstromsignal $I_{inj}^{F}(t)$ gilt, dass es bei Anwendung der Überlagerungsmethode für die Zeitpunkte t≥0 dem gemessenen Injektionsstromsignal $i_{inj}(t)$ gleichzusetzen ist, da der Injektionsvorgang bei t=0 gestartet wird und daher das Injektionsstromsignal für die Zeitpunkte t<0 gleich null sein muss. Deshalb ist auch dessen periodische Fortsetzung für die Zeitpunkte t≥0 gleich Null.

Unabhängig von der Art der Einbringung eines Injektionssignals ins Nullsystem des elektrischen Netzes kann das Ersatzschaltbild für die Erdschlusslöschspule und der Injektionseinheit in guter Näherung durch die Erdschlusslöschspulenimpedanz $X_n$, in Form einer Parallelschaltung der Erdschlusslöschspuleninduktivität L mit einem, die Eisenverluste der Erdschlusslöschspule beschreibenden und durch dessen Konduktanz $G_n$ repräsentierten, Widerstand, und mit der Stromquelle für das Injektionssignal $I_{inj}$ dargestellt werden, wie in Fig. 3 gezeigt. Die Berücksichtigung der Kupferverluste der Erdschlusslöschspule kann durch das Einfügen eines ohmschen Widerstandes in Serie mit der Induktivität L in einfacher Weise erfolgen, wodurch sich lediglich die Ordnung der Modellgleichungen erhöhen würde, aber die Anwendbarkeit des Verfahrens in keiner Weise eingeschränkt werden würde. Die Nulladmittanz $Y_0$ des Netzes kann ohne zusätzliche Erdschlusslöschspulen im Netz für den betrachteten Frequenzbereich in guter Näherung durch deren kapazitiven Anteil $C_0$ parallel mit der Nullkonduktanz $G_0$ angenommen werden. Die Induktivität $L_1$ repräsentiert eventuell im Netz vorhandene zusätzliche Erdschlusslöschspulen. Deren Eisenverluste werden in $G_0$ mit berücksichtigt. Die Stromquelle $I_v$ beschreibt die Unsymmetrieströme des Gesamtnetzes entsprechend der obigen Gleichung.

Über grundlegende Beziehungen in diesem Ersatzschaltbild erhält man die bekannte Resonanzbedingung für die Resonanzkreisfrequenz $\omega_{res}$ des Nullsystems des Netzes mit

$$\omega_{res} = \sqrt{1/(L' \cdot C_0)}, \text{ mit } L' = \frac{L_1 \cdot L}{L_1 + L}.$$

Sind nun zur ausreichend genauen Messung der beiden Größen $U_{ne}(t)$ und $i_0(t)$ geeignete Messeinrichtungen verfügbar, so können deren Messwerte bezüglich eines eingespeisten Frequenzspektrums zur Durchführung eines Verfahrens zur Bestimmung der Netzparameter $G_0$, $C_0$ und $L_1$, z.B. hinlänglich bekannte Parameterschätzverfahren, verwendet werden, wie weiter unten beschrieben.

Ferner können die obigen Gleichungen in äquivalenter Weise auch als grundlegende Gleichungen zur Entwicklung eines Verfahrens zur Bestimmung der Parameter des Nullsystems von Leitungsabschnitten oder Leitungsabzweigen verwendet werden, wenn die Laplace-Transformierte des gefilterten Nullstrommesssignales des überwachten Leitungsabschnittes oder Leitungsabzweiges und die Laplace-Transformierte des gefilterten Sternpunkt-Erdspannungsmesssignals verwendet wird. Die ermittelten Parameter entsprechen dann den Nullsystemparametern des überwachten Leitungsabschnittes oder Leitungsabzweiges. Die derart ermittelten Abschnittsparameter könnten z.B. zur Erkennung und Ortung von Erdfehlern verwendet werden.

Üblicherweise bereitet die Messung des Nullstromes $i_0(t)$ keine Probleme, da dazu geeignete Stromwandler in der Mehrzahl der Anwendungen vorhanden sind. Anders verhält es sich jedoch bei der Messung der Sternpunkt-Erdspannung $U_{ne}$, sofern nicht eine direkte Messeinrichtung zur Messung der Sternpunkt-Erdspannung oder alternativ drei Spannungswandler zur Messung der drei Phasenerdspannungen mit nachfolgender Verschaltung der Sekundärwicklungen im offenen Dreieck anlagenseitig vorhanden sind. Die üblicherweise bei Erdschlusslöschspulen verfügbaren Messwicklungen für die Messung der Sternpunkt-Erdspannung sind für diesen Zweck kaum geeignet, da einerseits magnetische Einflüsse innerhalb der Erdschlusslöschspule die Messung beeinträchtigen und andererseits die Streuinduktivitäten und Kupferwiderstände der Sternwicklung des Transformators zusammen mit den Phasenströmen Spannungsabfälle im Nullsystem verursachen, die real im Netz vorhanden sind, jedoch von dieser Messwicklung nicht mit gemessen werden.

Durch die Verwendung des, aufgrund eines Injektionsmodells aus einem messbaren (äußeren) Injektionssignal rekonstruierten, modellhaften Injektionsstromsignales $i_{inj}(t)$ des Ersatzschaltbildes nach Fig.3 und der Messwerte des Nullstromes, also des Löschspulenstromes, $i_0(t)$ als Eingangsgrößen ergibt sich unter Berücksichtigung der oben beschriebenen Zusammenhänge eine alternative Möglichkeit für die Durchführung eines Verfahrens zur Bestimmung der Netzparameter, wie z.B. $G_0$, $C_0$ und $L_1$. Aus grundlegenden Beziehungen am Ersatzschaltbild nach Fig. 3 und unter Verwendung der Erdschlusslöschspulenimpedanz

$$X_n(s) = \frac{L.s}{1 + (G_n.L).s}$$

ergibt sich die Beziehung

$$[i_0^F(s).G_1(s)] - [i_{inj}^F(s) - i_0^F(s)].[(\frac{L}{L_1}).\frac{1}{s} + (G_0.L) + (C_0.L).s] = 0$$

$$\text{mit } G_1(s) = \frac{1}{s} + (G_n L).$$

Damit hat man einen Zusammenhang zwischen den Größen Injektionsstromsignal $i_{inj}(t)$ und Nullstrom $i_0(t)$ und den Netzparametern $G_0$, $C_0$ und $L_1$. Diese Beziehung kann wiederum zur Bestimmung der Netzparameter $G_0$, $C_0$ und $L_1$, z.B. mittels hinlänglich bekannter Bestapproximationsverfahren, wie z.B. mittels dem bekannten RLS Algorithmus, verwendet werden.

Der Nullstrom $i_0(t)$ kann dabei mittels eines Stromwandlers oder einer anderen geeigneten Messeinrichtung direkt als der in der Erdschlusslöschspule fließende Strom gemessen werden, da nach Fig.1 bzw. 2 der Nullstrom $i_0(t)$ über die Erdschlusslöschspule zum Wicklungssternpunkt des Transformators zurück fließen muss. Schwieriger gestaltet sich die Bestimmung des durch eine Stromquelle repräsentierten Injektionsstromes $i_{inj}(t)$, da dieser Strom, der im Injektionsmodell durch Zweipolumformung entsteht, eine Modellgröße darstellt und daher nicht direkt messbar ist. Es lässt sich aber zeigen, dass unabhängig von der Art der Einbringung eines Injektionssignals ins Nullsystem des Netzes, also entweder in Form einer in Serie zur Erdschlusslöschspule geschalteten Spannungsquelle oder durch parallel zur Erdschlusslöschspule erfolgende Einspeisung mit einer Stromquelle, ein funktionaler, in manchen Fällen nahezu proportionaler, Zusammenhang zwischen dem tatsächlichen und daher messbaren Injektionssignal und dem modellartigen Injektionsstrom $i_{inj}(t)$ hergestellt werden kann. Daher kann der Injektionsstrom $i_{inj}(t)$ des Injektionsmodells immer aus einer Messgröße des zugänglichen und daher tatsächlich messbaren Injektionssignals unter Verwendung der durch die Art der Injektion bedingten Zusammenhänge berechnet werden. Im Sinne dieser Erfindung können die beiden Größen, nämlich die Modellgröße Injektionsstrom $i_{inj}(t)$ und die messbare Größe Injektionssignal, daher als gleichwertige Größen aufgefasst werden.

Dieser oben beschriebene Zusammenhang zwischen dem Injektionssignal $i_{inj}$ und dem Nullstrom, ohne die Verlagerungsspannung $U_{ne}$, zur Ermittlung der Parameter eines elektrischen Netzes oder eines Abschnitts bzw. Abzweigs davon, ist als solches ebenfalls als erfinderisch anzusehen, da es damit möglich ist, eine nur schwer oder nicht messbare Größe, wie z.B. die Verlagerungsspannung $U_{ne}$, aus dem funktionalen Zusammenhang zu eliminieren bzw. durch eine messbare Größe, wie eben das Injektionssignal $i_{inj}$, zu ersetzen.

Es ist aber selbstverständlich auch möglich, aus dem Modell einen Zusammenhang zwischen dem aus einen messbaren (äußeren) Injektionssignal rekonstruierten Injektionsstromsignal $I_{inj}(t)$ und den Messwerten der Sternpunkt-Erdspannung $U_{ne}(t)$ herzustellen und zur Bestimmung der Netzparameter, wie z.B. $G_0\,C_0$ und $L_1$, zu verwenden. Durch einfache Umformungen des funktionalen Zusammenhangs zwischen den gefilterten Größen des Injektionsstromsignals und der Sternpunkt-Erdspannung, erhält man letztendlich den gewünschten Zusammenhang mit

$$I_{inj}^{F}(s) - U_{ne}^{F}(s) \cdot G - U_{ne}^{F}(s) \cdot s \cdot C_0 - \left[\frac{U_{ne}^{F}(s)}{s}\right] \cdot \frac{1}{L'} = 0$$

und

$$G = G_0 + G_n \quad \text{und} \quad L' = \frac{L_1 L}{L_1 + L} \cdot$$

Generell kann also gesagt werden, dass sich die Parameter des Gesamtnetzes immer aus einem funktionalen Zusammenhang zwischen zwei der messbaren Größen, nämlich Nullstrom $i_0$, Sternpunkt-Erdspannung $U_{ne}$ und Injektionsstromsignal $i_{inj}$, bestimmen lassen.

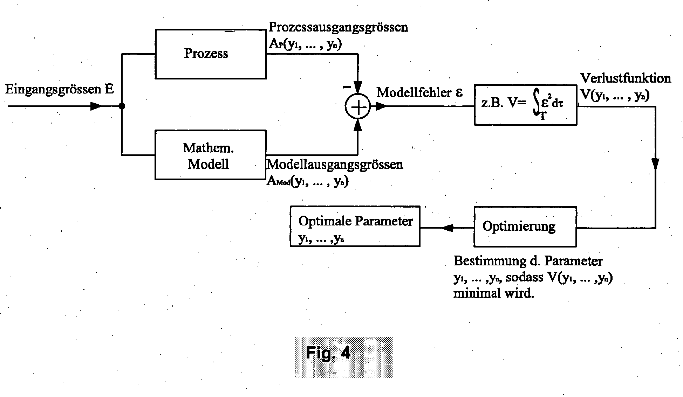

Ein mögliches Schätzverfahren zur Bestimmung der Netzparameter wird im Nachfolgenden unter Bezugnahme auf das das Verfahren verdeutlichende Blockschaltbild nach Fig. 4 skizziert. Aufgrund der, die Dynamik des Prozesses beschreibenden, Modellgleichungen ist es wie oben erläutert möglich, die Prozessausgangsgrößen A des Modells als Funktion der messbaren Prozesseingangsgrößen E und der unbekannten inneren Prozessparameter y zu beschreiben. Bildet man nun die Differenz von diesen, mathematisch als Funktion der gemessenen Eingangsgrößen E und der unbekannten inneren Prozessparameter (also den Netzparametern) y beschriebenen, Prozessausgangsgrößen $A_{Mod}$ und den tatsächlich gemessenen Ausgangsgrößen Ap, so erhält man den so genannten Modellfehler $\varepsilon$ (bzw. eine Modellfehlerfunktion), also die Abweichung der durch das mathematische Modell mit den unbekannten inneren Parametern errechneten Ausgangsgrößen von den tatsächlich gemessenen. Die Aufgabe lautet folglich, die unbekannten inneren Parameter y so zu bestimmen, dass die bei gegebenen Eingangsgrößen E mit dem mathematischen Modell und mit diesen Parametern berechneten Ausgangsgrößen A weitgehend den wirklich gemessenen Ausgangsgrößen entsprechen, also eine sich aus den Modellfehlerfunktionen $\varepsilon$ über den betrachteten Beobachtungszeitraum ergebende Verlustfunktion V minimiert wird.

Üblicherweise werden die Messwerte der Eingangsgrößen E und Ausgangsgrößen A des Prozesses während einer Anregung des Systems zu äquidistanten Zeitpunkten mit einer, an die Dynamik des Prozesses angepassten, Abtastfrequenz abgetastet, A/D konvertiert, gegebenenfalls vorgefiltert und vorzugsweise zur Weiterverarbeitung digital gespeichert. Die oben genannte Modellfehlerfunktion $\varepsilon$ kann somit als Funktion der inneren Prozessparameter y für jeden Messwertsample des Beobachtungszeitraumes bestimmt werden. Im Fall einer Ausgangsgröße ist diese Modellfehlerfunktion $\varepsilon$ eindimensional. Die Verlustfunktion V ist dann beispielsweise durch Bildung der Summe der Quadrate der Modellfehlerfunktion $\varepsilon$ über alle Samples des Beobachtungszeitraumes festgelegt. Die Quadrate der Modellfehlerfunktion $\varepsilon$ können auch bei Bedarf mit Gewichtungsfaktoren gewichtet werden. Damit können besonders vorteilhafte Systemzustände bezüglich der Konditionierung des Schätzverfahrens in ihrer Bedeutung hervorgehoben und weniger vorteilhafte bezüglich ihres Einflusses auf das Schätzergebnis eher unterdrückt werden.

Somit entspricht die Bestimmung der inneren Parameter einem Optimierungsproblem, eben der Bestimmung jener optimalen inneren Parameter y nach einer äußeren Anregung des dynamischen Prozesses, bei denen die, sich aus den Differenzen der berechneten Modellausgangsgrößen $A_{Mod}$ und den tatsächlich gemessenen Ausgangsgrößen $A_P$ ergebende Modellfehlerfunktion $\varepsilon$ über einen Beobachtungszeitraum zur Bestimmung einer Verlustfunktion V benützt wird und diese Verlustfunktion V als Funktion der inneren Parameter y minimiert wird.

Die oben beschriebene Art der Bestimmung innerer Prozessparameter wird üblicherweise als Blockverarbeitung bezeichnet, da ein ganzer Datenblock zur Bestimmung der Prozessparameter verwendet wird.

Eine andere Möglichkeit der Parameterbestimmung deterministischer parametrischer Prozessmodelle ergibt sich durch die Anwendung rekursiver Parameterschätzverfahren. Bei diesen Verfahren werden die messbaren (äußeren) Größen, also die Eingangs- und Ausgangsgrößen des Prozesses zu äquidistanten Zeitpunkten abgetastet und gemessen und die zum (k+1)-ten Zeitpunkt ermittelten Schätzgrößen unter Berücksichtigung der zum (k+1)-ten Zeitpunkt gemessenen Eingangs- und Ausgangsgrößen und den zum (k)-ten Zeitpunkt ermittelten Schätzgrößen, also rekursiv, bestimmt. Da diese rekursive Art der Bestimmung der inneren Prozessparameter gegenüber der so genannten Blockverarbeitung einen normalerweise höheren Rechenaufwand bedingt, werden die auf der Grundlage der Blockverarbeitung beruhenden Algorithmen für diese Art der Problemstellung bevorzugt. Es sei jedoch erwähnt, dass auch diese rekursiven Methoden qualitativ vergleichbare Schätzergebnisse liefern können und folglich ebenfalls verwendet werden könnten.

Wie der einschlägigen Literatur zu entnehmen ist, existieren eine Fülle von bekannten Lösungsansätzen zur Parameterbestimmung von solchen deterministischen parametrischen Prozessen. Alle diese Methoden haben gemein, dass während einer Anregung des Prozesses die Messwerte der messbaren äußeren Größen des Prozesses, also Eingangs- und Ausgangsgrößen, zu meist zeitlich äquidistanten Zeitpunkten mit einer bezüglich der Prozessdynamik geeignet gewählten Abtastfrequenz abgetastet und mit einem oder mehreren Analog/Digitalwandlern in digitale Werte umgeformt sowie bei Bedarf gefiltert werden und diese digitalen Messwertsamples entweder rekursiv oder blockweise in einem Algorithmus zur Bestimmung der Prozessparameter weiterverarbeitet werden.

Die Grundlage aller Methoden zur Bestimmung der Prozessparameter ist üblicherweise ein deterministisches parametrisches Prozessmodell, bei dem ein formelmäßiger Zusammenhang zwischen den messbaren Eingangs- und Ausgangsgrößen des Prozesses mit den Prozessparametern als unbekannte Variable, gegebenenfalls durch zusätzliche Berücksichtigung von Rauschquellen, hergeleitet wird. Die Digitalwerte der Ausgangsgrößen des Modells werden während einer Anregung des Systems (Prozesses) aus den Messwertsamples der messbaren (und gegebenenfalls vorgefilterten) Eingangsgrößen und den, von den inneren Prozessparametern als unbekannte Variable abhängigen, Gleichungen des Prozessmodells bestimmt. Durch Bildung der Differenz zwischen den Ausgangsgrößen des Modells und den tatsächlich durch Messwertabtastung gewonnenen (und gegebenenfalls vorgefilterten) Ausgangsgrößen kann für jeden Sample die Modellfehlerfunktion als Funktion der inneren Prozessparameter bestimmt werden. Aufgrund der Definition einer Verlustfunktion, beispielsweise der Summe der Quadrate der Modellfehlerfunktion über alle Samples des Beobachtungszeitraumes, kann dann diese Verlustfunktion als Funktion der inneren Parameter aufgefasst werden und die optimalen inneren Parameter im Sinne eines Optimierungsproblems derart bestimmt werden, dass die Verlustfunktion für diesen optimalen Parametersatz minimal wird (Blockverarbeitung), oder durch Verwendung der im (k)-ten Sample ermittelten Parameter und der im (k+1)-ten Sample abgetasteten, A/D konvertierten und gegebenenfalls gefilterten Messwertsamples der Eingangs- und Ausgangsgrößen des Prozesses die inneren Parameter für den (k+1)-ten Sample im Sinne der Minimierung einer Verlustfunktion bestimmt werden (rekursiver Algorithmus).

Nachfolgend wird beispielhaft und ohne Einschränkung ein mögliches Verfahren zur Bestimmung der Netzparameter im Zeitbereich beschrieben. Aus den obigen Ausführungen ist jedoch klar, dass es daneben noch eine Fülle weiterer geeigneter Verfahren, insbesondere auch Verfahren im Frequenzbereich, gibt, die ebenfalls zur Anwendung kommen könnten.

Die oben dargestellte grundsätzliche Methode zur Bestimmung der inneren Prozessparameter soll nun anwendungsbezogen auf das Problem der Bestimmung der Netzparameter des Nullsystems eines sternpunktkompensierten Netzes durch beispielhafte Anwendung eines einfachen Verfahrens vorgeführt werden. Wie bereits oben erwähnt lassen sich damit aber analog natürlich auch die Parameter einzelner Leitungsabschnitte oder -abzweige bestimmen, was aufgrund der Analogie hier aber nicht im Detail beschrieben wird. Bezug nehmend auf die obigen Gleichungen des Prozessmodells wird beispielhaft und ohne Einschränkung ein Algorithmus vorgestellt, der als Messgrößen die Messwerte des gefilterten Nullstromes $I_0(t)$ und der gefilterten Sternpunkt-Erdspannung $U_{ne}(t)$ verwendet.

Die Rücktransformation der obigen Gleichungen in den Zeitbereich zeigt, dass sich ohne Berücksichtigung der Anfangsbedingungen das zeitliche Signal des gefilterten Nullstromsignals im Prozessmodell als Linearkombination vom Zeitsignal des gefilterten Sternpunkt-Erdspannungssignals sowie dessen zeitlicher Ableitung und dessen Zeitintegrales beschreiben lässt, also:

$$I^F_{0MODELL}(t) - \left[U^F_{ne}(t)\right]G_0 - \left[dU^F_{ne}(t)/dt\right]C_0 - \left[\int_0^t U^F_{ne}(\tau).d\tau\right].(1/L_1) = 0 .$$

Es sei an dieser Stelle erwähnt, dass die Struktur dieser Gleichung auch erhalten bleibt, wenn man die in der obigen Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.

Wird nun der Modellfehler $\varepsilon(t)$ derart definiert, dass $\varepsilon(t) = (I^F_0(t) - I^F_{0MODELL}(t))$, dann folgt für die Modellfehlergleichung für den Zeitpunkt t als Funktion des tatsächlich gemessenen und gefilterten Messsignals des Nullstromes $I^F_0(t)$ sowie des gemessenen und gefilterten Messsignals der Sternpunkt-Erdspannung $U_{ne}(t)$ und dessen zeitlicher Ableitung sowie dessen Integrales bezüglich der Zeit:

$$I_0^F(t) - \left[U_{ne}^F(t)\right]G_0 - \left[dU_{ne}^F(t)/dt\right]C_0 - \left[\int_0^t U_{ne}^F(\tau).d\tau\right].(1/L_1) = \varepsilon(t).$$

Diese Beziehung bildet die Grundlage für ein Parameterschätzverfahren, das wie folgt ablaufen kann:

1) Sind durch geeignete Messeinrichtungen sowohl geeignete Messwerte vom, die Erdschlusslöschspule durchfließenden, Nullstrom $I_0(t)$ als auch von der Sternpunkt-Erdspannung $U_{ne}(t)$ verfügbar, so können deren Messwerte zu zeitlich äquidistanten Zeitpunkten mit einer an die Systemdynamik angepassten Abtastfrequenz abgetastet werden. Deren abgetastete und nachfolgend mit einem A/D Konverter digitalisierte Werte zum (n)-ten Abtastzeitpunkt werden mit $I_0(n)$ und $U_{ne}(n)$ bezeichnet. Die Messwertabtastung erfolgt zumindest während der Injektion nicht netzfrequenter Signale ins Nullsystem, vorzugsweise aber kontinuierlich.

2) Digitale Filterung der Folgen von $I_0(n)$ und $U_{ne}(n)$ mithilfe der bereits beschriebenen, für beide Messwertfolgen identischen, Sperrfilterblöcke zur Ausfilterung der netzfrequenten Grundwellenanteile sowie der Oberwellenanteile mit jenen Frequenzen, die den ganzzahlig ungeradzahligen Vielfachen der Netzfrequenz entsprechen oder Anwendung des Superpositionsprinzips zur Elimination der durch den Unsymmetriestrom verursachten Signalanteile aus den obigen Messwertfolgen, zumindest während der Injektionszeit, vorzugsweise aber kontinuierlich. Die Signalwertefolgen der gefilterten Größen werden mit $I_0^F(n)$ und $U_{ne}^F(n)$ bezeichnet. Es sei noch erwähnt, dass die beiden identischen Filterblöcke bei Bedarf noch um bandbreitenbegrenzende Hoch- und Tiefpassfilter erweitert werden könnten.

3) Zu oder vor Beginn des Injektionsvorganges wird bei n = 0 mit dem blockverarbeitenden Algorithmus begonnen und die gefilterten Signale für den jeweils (n)-ten Signalwert mit $f(n) = I_0^F(n)$ und $f_1(n) = U_{ne}^F(n)$ bezeichnet.

4) Numerische Berechnung der Signalwertefolge der ersten Ableitung bezüglich der Zeit von der Signalwertefolge $f_1(n)$ mithilfe der Bilineartransformation oder anderer bekannter numerischer Differentiationsmethoden für Abtastwertefolgen. Bezeichnung der entstehenden, der ersten Ableitung der Abtastwertefolge von $f_1(n)$ bezüglich der Zeit entsprechenden, Abtastwertefolge durch $f_2(n)$.

5) Numerische Berechnung der Signalwertefolge des Integrales bezüglich der Zeit von der Signalwertefolge $f_1(n)$ mithilfe der Bilineartransformation oder anderer numerischer Integrationsmethoden für Abtastwertefolgen, beispielsweise nach der Simpsonformel oder der Trapezregel. Bezeichnung der entstehenden, dem Integral bezüglich des Zeitintervalls von der 0-ten bis zur (n)-ten Abtastung der Abtastwertefolge von $f_1(n)$ entsprechenden, Abtastwertefolge durch $f_3(n)$. Der Startwert $f_3(0)$ ist gleich Null zu setzen.

6) Entsprechend den obigen Gleichungen ergibt sich somit für den Modellfehler zum (n)-ten Abtastzeitpunkt folgende Gleichung für alle zwischen Null und N liegenden ganzzahligen Indizes n:

$$f(n) - f_1(n).x_1 - f_2(n).x_2 - f_3(n).x_3 = \varepsilon(n) \quad \forall\, n \in \{0,1,2,...,N\} \quad .$$

Die unbekannten inneren Prozessparameter werden dabei durch die Variablen $x_1$, $x_2$ und $x_3$ repräsentiert.

7) Berechnung der so genannten inneren Produkte gemäß den folgenden Formeln. Die jeweiligen Summen sind über (N+1) Abtastungen zu bilden. Idealerweise wird N so gewählt, dass die Anzahl der vom Algorithmus benützten und bewerteten Abtastungen den gesamten Injektionsvorgang zeitlich gesehen überdeckt. Vor oder zu Beginn des Injektionsvorganges wird mit n=0 gestartet.

$$c_{kj} = \sum_{n=0}^{N} f_k(n) \cdot f_j(n) \qquad \forall\, k,j \in \{1,2,3\}$$

und

$$b_k = \sum_{n=0}^{N} f(n) \cdot f_k(n) \qquad \forall\, k \in \{1,2,3\}$$

8) Die inneren Produkte $c_{kj}$ sind nun als Elemente einer (3x3) Matrix $\underline{C}$ und die inneren Produkte $b_k$ sind als (k)-te Koeffizienten eines Vektors $\underline{b}$ aufzufassen. Die Gleichung $\underline{C} \cdot \underline{x} = \underline{b}$ beschreibt somit ein lineares Gleichungssystem 3.Ordnung, dessen Lösungsvektor $\underline{x}$ jene Netzparameter repräsentiert, bei denen die Verlustfunktion, also in diesem Fall die Summe der Modellfehlerquadrate über den Beobachtungszeitraum, der idealer Weise den Injektionszeitraum überdeckt, minimiert wird. Die Lösung des linearen Gleichungssystems zur Bestimmung des Lösungsvektors kann mit jedem bekannten Verfahren zur Lösung linearer Gleichungssysteme durchgeführt werden. Durch einfache, hier nicht dargestellte, Gewichtung der Modellfehlerquadrate kann der Algorithmus bei Bedarf erweitert werden. Die Komponenten $x_1$, $x_2$ und $x_3$ des Lösungsvektors entsprechen dabei den, bezüglich der Verlustfunktion optimalen, Netzparametern $G_0$, $C_0$ und $(1/L_1)$, die damit bestimmt sind. Aus den Parametern können dann zusammen mit anderen Größen natürlich weitere Parameter oder Kennwerte des Netzes, wie z.B. der Unsymmetriestrom $i_v$, der Wattreststrom, der Spulenresonanzstrom, etc., berechnet werden.

Ein zweites Beispiel ergibt sich durch die Verwendung des, mithilfe eines Injektionsmodelles aus einem messbaren Injektionssignal rekonstruierten, Injektionsstromsignales $I_{inj}(t)$ und der Messwerte des Nullstromes, also des Löschspulenstromes, $I_0(t)$ als Eingangsgrößen für die Durchführung eines Verfahrens zur Bestimmung der Netzparameter $G_0$, $C_0$ und $L_1$. Die grundlegende Gleichung des Prozessmodells mit diesen Eingangsgrößen wurde oben bereits erläutert. Der Algorithmus verwendet als Signalgrößen die Messwerte des mithilfe oben genannter Sperrfilter oder der Superpositionsmethode gefilterten Nullstroms $I_0^F(t)$ und den durch Verwendung der Zusammenhänge des Injektionsmodells rekonstruierten und nachfolgend mit oben genannten Sperrfiltern oder der Superpositionsmethode gefilterten Injektionsstrom $I_{inj}^F(t)$. Daraus folgt mit $H(s) = I_0^F(s) \cdot G_1(s)$ und $F(s) = I_{inj}^F(s) - I_0^F(s)$ und Rücktransformation in den Zeitbereich

$$H_{MODELL}(t) - [F(t)](G_0 \cdot L) - [dF(t)/dt](C_0 \cdot L) - \left[\int_0^t F(\tau) \cdot d\tau\right] \cdot (L/L_1) = 0.$$

Es sei an dieser Stelle erwähnt, dass die Struktur dieser Gleichung auch erhalten bleibt, wenn man die in der Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.

Durch Vergleich dieser Beziehung mit der grundlegenden Beziehung des oben beschriebenen Verfahrens ist klar die Analogie dieser beiden Methoden zu erkennen. Es wird daher darauf verzichtet, dieses zweite Beispiel zur Bestimmung der Netzparameter nochmals detailliert darzulegen, da die Verfahrensschritte analog zum oben beschriebenen Verfahren durchzuführen sind. Das Signal H(t) kann dabei als Ausgangsgröße des Übertragungsgliedes $G_1(s)$ aufgefasst werden, dessen Eingangssignal dem gefilterten Nullstromsignal $I_0^F(t)$ entspricht. Die Koeffizienten des Übertragungsgliedes $G_1(s)$, nämlich $G_n$ und

$L$, sind aufgrund der Kenntnis der Eisenverluste und der Erdschlusslöschspuleninduktivität bekannt. Somit können auch für dieses Beispiel die in der zugrunde liegenden Gleichung enthaltenen Netzparameter $G_0$, $C_0$ und $L_1$ eindeutig bestimmt werden, da die in den Schätzgrößen enthaltene Spuleninduktivität L der Erdschlusslöschspule für alle Beispiele der Erdschlusslöschspule als bekannt vorausgesetzt werden kann.

Aus dem weiter oben angegebenen Zusammenhang zwischen Verlagerungsspannung $U_{ne}$ und dem Injektionsstromsignal $I_{inj}$ erhält man durch Rücktransformation in den Zeitbereich

$$I^F_{injMODELL}(t) - \left[U^F_{ne}(t)\right]G - \left[dU^F_{ne}(t)/dt\right]C_0 - \left[\int_0^t U^F_{ne}(\tau).d\tau\right].(\frac{1}{L'}) = 0 \,.$$

Diese Beziehung zeigt, dass sich das zeitliche Signal des gefilterten Injektionsstromsignals $I_{inj}$ im Prozessmodell ohne Berücksichtigung der Anfangsbedingungen als Linearkombination vom Zeitsignal des gefilterten Sternpunkt-Erdspannungssignals $U_{ne}$ sowie dessen zeitlicher Ableitung und dessen Zeitintegrals beschreiben lässt. Wird nun der Modellfehler $\varepsilon(t)$ wie gehabt definiert, $\varepsilon(t) = (I^F_{inj}(t) - I^F_{injMODELL}(t))$, folgt für die Modellfehlergleichung für den Zeitpunkt t als Funktion des, durch ein Injektionsmodell aus einem tatsächlich gemessenen Injektionssignal rekonstruierten und nachfolgend gefilterten Signals des Injektionsstromes $I^F_{inj}(t)$, sowie des gemessenen und gefilterten Messsignals der Sternpunkt-Erdspannung $U^F_{ne}(t)$ und dessen zeitlicher Ableitung, sowie dessen Zeitintegrals

$$I^F_{inj}(t) - \left[U^F_{ne}(t)\right]G - \left[dU^F_{ne}(t)/dt\right]C_0 - \left[\int_0^t U^F_{ne}(\tau).d\tau\right].(\frac{1}{L'}) = \varepsilon(t) \,.$$

Daraus können wieder in Analogie zu oben, die Parameter ermittelt werden.
Es sei an dieser Stelle wieder erwähnt, dass die Struktur dieser Gleichung auch erhalten bleibt, wenn man die in der Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.
Aus dieser Beziehung kann nun auch eine besonders vorteilhafte Vereinfachung hergeleitet werden. Wird das Injektionssignal impulsartig eingebracht und sei der Zeitpunkt $t_1 > 0$ derart gewählt, dass $I^F_{inj}(t) = 0$ für $t \geq t_1$, man betrachtet also die Zeitspanne nachdem der Impuls eingebracht wurde, dann folgt daraus durch Differenzenbildung für alle $t \geq t_1$ ein funktionaler Zusammenhang bezüglich einer einzigen Größe, hier der Verlagerungsspannung $U_{ne}$, der Form

$$\left[U^F_{ne}(t) - U^F_{ne}(t_1)\right]G + \left[dU^F_{ne}(t)/dt - dU^F_{ne}(t_1)/dt\right]C_0 + \left[\int_{t_1}^t U^F_{ne}(\tau).d\tau\right].(\frac{1}{L'}) = -\varepsilon(t) \,.$$

Es sei an dieser Stelle wieder erwähnt, dass die Struktur dieser Gleichung auch erhalten bleibt, wenn man die in der Gleichung vorkommenden zeitabhängigen Funktionen durch deren zeitliche Integrale oder deren Ableitungen bezüglich der Zeit ersetzt. Eine derartige beliebig wiederholbare Maßnahme ist daher als gleichwertig zum beschriebenen Verfahren anzusehen.
Dividiert man diese Gleichung ohne Beschränkung der Allgemeinheit durch $C_0$, dann erhält man mit

$$f(t) = \left[dU^F_{ne}(t_1)/dt - dU^F_{ne}(t)/dt\right],$$

$$f_1(t) = \left[U^F_{ne}(t) - U^F_{ne}(t_1)\right],$$

$$f_2(t) = \left[ \int_{t_1}^{t} U_{ne}^{F}(\tau).d\tau \right],$$

$$x_1 = (G / C_0)$$

und

$$x_2 = \left( \frac{1}{L'.C_0} \right)$$

die Gleichung

$$f(t) - f_1(t).x_1 - f_2(t).x_2 = \varepsilon(t) \quad \forall\, t > t_1.$$

Durch zeitlich äquidistante Abtastung des Messsignals der Sternpunkt-Erdspannung $U_{ne}$ und der Durchführung geeigneter numerischer Methoden zur Berechnung dessen zeitlicher Ableitung sowie dessen Zeitintegrals in der bereits beschriebenen Weise erhält man weiter $f(n)-f_1(n).x_1-f_2(n).x_2 = \varepsilon(n) \,\forall\, n \in \{1,2,...,N\}$, wobei der Startzeitpunkt, also der Zeitpunkt des ersten Samples, größer oder gleich $t_1$ zu wählen ist. Durch Berechnung von

$$c_{kj} = \sum_{n=1}^{N} f_k(n) \cdot f_j(n) \qquad \forall\, k,j \in \{1,2\}$$

und

$$b_k = \sum_{n=1}^{N} f(n) \cdot f_k(n) \qquad \forall\, k \in \{1,2\}$$

erhält man wieder die Koeffizienten eines linearen Gleichungssystems, wobei die inneren Produkte $c_{kj}$ nun als die Elemente einer (2x2) Matrix $\underline{C}$ und die inneren Produkte $b_k$ als (k)-te Koeffizienten eines Vektors $\underline{b}$ aufzufassen sind. Die Gleichung $\underline{C} \cdot x = \underline{b}$ beschreibt somit ein lineares Gleichungssystem 2. Ordnung, dessen Lösungsvektor $\underline{x}$ jene Parameter repräsentiert, bei denen die Verlustfunktion, also in diesem Fall die Summe der Modellfehlerquadrate über das Bewertungszeitintervall, minimiert wird. Die Lösung des linearen Gleichungssystems zur Bestimmung des Lösungsvektors kann mit jedem bekannten Verfahren zur Lösung linearer Gleichungssysteme durchgeführt werden. Durch einfache, hier nicht dargestellte Gewichtung der Modellfehlerquadrate kann der Algorithmus bei Bedarf erweitert werden. Die Komponenten $x_1$ und $x_2$ des Lösungsvektors entsprechen dabei den, bezüglich der Verlustfunktion optimalen, Parametern (G/C$_0$) und $\left( \frac{1}{L'.C_0} \right)$. Dabei ist speziell der Parameter $\left( \frac{1}{L'.C_0} \right)$ von besonderer Bedeutung, da er das Quadrat der Resonanzkreisfrequenz $\omega_{res}$ des

Nullsystems des Netzes repräsentiert. Da die impulsartige Injektion auch während des Abstimmvorganges der Erdschlusslöschspule ständig wiederholt werden kann, ist es mit diesem Verfahren möglich, die Erdschlusslöschspule solange abzustimmen, bis die Resonanzkreisfrequenz $\omega_{res}$ den gewünschten Wert annimmt. Bei diesem Verfahren wird als Netzparameter die bei der momentan gegebenen Induktivität der Erdschlusslöschspule ermittelte Resonanzkreisfrequenz $\omega_{res}$ des Nullsystems des Netzes bestimmt, die zur Abstimmung der Erdschlusslöschspule vorteilhaft verwendet werden kann.

Natürlich kann diese wichtige Vereinfachung, nämlich dass das Injektionssignal impulsartig eingebracht und der Startzeitpunkt der Bewertung der Messwerte $t_1>0$ derart gewählt wird, dass für die Zeitpunkte $t>t_1$ der Injektionsstrom $i_{inj}$ bereits als Null angenommen werden kann, auch auf den funktionalen Zusammenhang zwischen den Signalen des Injektionsstromes $i_{inj}$ und des Nullstromes $i_0$ angewandt werden, woraus der Injektionsstrom $i_{inj}$ durch Differenzenbildung wieder eliminiert werden kann. Als Resultat erhält man in analoger Weise zum dargelegten obigen Verfahren wieder ein lineares Gleichungssystem 2. Ordnung, dessen Lösungsvektor als Netzparameter die momentane Resonanzkreis-frequenz $\omega_{res}$ des Nullsystems des Netzes beinhaltet.

Selbstverständlich kann diese wichtige Vereinfachung, nämlich dass das Injektionssignal impulsartig eingebracht und der Startzeitpunkt der Bewertung der Messwerte $t_1>0$ derart gewählt wird, dass für die Zeitpunkte $t>t_1$ der Injektionsstrom $i_{inj}$ bereits als Null angenommen werden kann, auch auf den funktionalen Zusammenhang zwischen den Messsignalen der Sternpunkt-Erdspannung $U_{ne}$ und des Nullstromes $i_0$ angewandt werden, wenn die Anfangsbedingungen in geeigneter Weise, zum Beispiel durch Differenzbildung, berücksichtigt werden. Diese Methode erlaubt dann wieder die Parameterbestimmung in der üblichen Weise, sowohl für das Gesamtnetz als auch für Abzweigparameter.

Ferner kann durch Berechnung der Fouriertransformierten oder der DFT oder FFT für die zu den Zeitpunkten $t>t_1$ ermittelten Messwerte der Sternpunkt-Erdspannung $U_{ne}$ bzw. des Nullstromes $i_0$ die Resonanzkreisfrequenz $\omega_{res}$ ebenfalls einfach bestimmt werden, da klar ist, dass deren Zeitsignale für die Zeitpunkte $t>t_1$ dem Ausschwingvorgang eines durch einen impulsartigen Vorgang angeregten Parallelschwingkreis, also einem exponentiell abklingenden sinusartigen Signal, entsprechen muss. Bildet man nun die Fouriertransformierte, DFT oder FFT für die zu den Zeitpunkten $t>t_1$ ermittelten Messwerte der Sternpunkt-Erdspannung $U_{ne}$ bzw. des Nullstromes $i_0$, so wird die Kreisfrequenz jenes Spektralanteiles, dessen Betrag am größten von allen ist, zumindest näherungsweise der Resonanzkreisfrequenz $\omega_{res}$ entsprechen.

Natürlich existiert eine Fülle weiterer Methoden zur Bestimmung der Resonanzkreisfrequenz $\omega_{res}$, die hier nicht in Ihrer Gesamtheit dargelegt werden können. Entscheidend für diese wichtige Methode ist, dass das Injektionssignal impulsartig eingebracht wird, ein Zeitpunkt $t_1$ festgelegt wird, ab dem angenommen werden kann, dass das Injektionssignal bereits Null bzw. nahezu Null ist und die zu den Zeitpunkten $t>t_1$ ermittelten Messwerte der Sternpunkt-Erdspan-nung $U_{ne}$ bzw. des Nullstromes $i_0$ einem Verfahren zur Bestimmung der Resonanzkreisfrequenz $\omega_{res}$ im Zeit- oder Frequenzbereich zugeführt werden.

Ebenso könnte man das Parameterschätzverfahren durch Substitution von s mit $j\omega$ und der sich beispielhaft aus dem funktionalen Zusammenhang von Verlagerungsspannung $U_{ne}$ und Nullstrom $i_0$ daraus ergebenden Beziehung

$$I_0^F(j.\omega_n) - U_{ne}^F(j.\omega_n).G_0 - j.U_{ne}^F(j.\omega_n).\omega_n.C_0 - U_{ne}^F(j.\omega_n)\frac{1}{j.\omega_n.L_1} = \varepsilon(\omega_n)$$

im Frequenzbereich durchführen. Dieses Verfahren zur Bestimmung der Netzparameter arbeitet nun mit den diskreten Spektren der diskreten Fourier-Transformation (DFT oder FFT) von den, in den beschriebenen Verfahren benützten, Abtastwertefolgen. Es lässt sich auch zeigen, dass sich die Methoden im Zeitbereich und im Frequenzbereich einander aufgrund der auf die Modellfehlerfunktion angewandten Parsevalschen Gleichung entsprechen und daher auch gleichwertige Ergebnisse erwarten lassen.

Vorteilhafterweise werden die Messwerte bzw. deren Abtastwertefolgen auch bei diesen Frequenzbereichsverfahren durch die beschriebenen Sperrfilterblöcke oder die beschriebene Superpositionsmethode in gleicher Weise wie bei den Zeitbereichsverfahren vorgefiltert, da dadurch sichergestellt wird, dass die Abtastwertefolgen dieser gefilterten Signale, die ja nachfolgend einer DFT oder FFT zugeführt werden, sowohl zu Zeitpunkten vor der Injektion als auch zu Zeitpunkten kurz nach der Beendigung der Injektion Null bzw. fast Null sind, sofern die Filterung der Signale mithilfe der beschriebenen Sperrfilterblöcke kontinuierlich durchgeführt wird oder zumindest einige Zeit vor dem Injektionsstart damit begonnen wurde oder die Superpositionsmethode angewandt wurde. Da zur Berechnung der DFT oder FFT nur jene Abtastwerte der, vom jeweiligen Verfahren benützten, Messwerte verwendet werden, die dem Zeitintervall von kurz vor bis kurz nach der Injektion zugeordnet werden können, kann aufgrund der Filterung der Signale durch die beschriebenen Sperrfilter oder durch die Superpositionsmethode davon ausgegangen werden, dass die Abtastwertefolgen der, dem DFT oder FFT Algorithmus zugeführten, Signale sowohl zu Beginn, also kurz vor dem Injektionsstart, als auch am Ende, also kurz nach dem Ende der Injektion, Null bzw. nahezu Null sind. Durch diese Maßnahme entfällt die Verwendung aufwändiger Fensterfunktionen. Natürlich besteht ohne Beschränkung der Funktionsweise auch die Möglichkeit, auf diese Filterung zu verzichten und die Verlustfunktion im Frequenzbereich so festzulegen, dass die netzfrequenten Signalanteile und auch jene Signalanteile, deren Frequenz ein ganzzahlig ungeradzahliges Vielfaches der Netzfrequenz aufweisen, in geeigneter Weise unterdrückt oder in der Verlustfunktion nicht berücksichtigt werden. Es ist aber zu bedenken, dass die, durch die spektralen Leckeffekte der dann zu verwendenden Fensterfunktionen verursachten, spektralen Verfälschungen bei der Anwendung dieser Methode erhalten bleiben und das Ergebnis in negativer Weise beeinträchtigen können.

Die Verfahren im Zeit- und Frequenzbereich sind als äquivalent anzusehen und liefern qualitativ gleichwertige Ergebnisse.

Es ist noch zu erwähnen, dass sich das oben beschriebene Verfahren natürlich auch für, das Nullsystem sternpunktkompensierter Netze genauer beschreibende, Prozessmodelle höherer Ordnung anwenden lässt, solange sich analog zu den obigen Gleichungen eine lineare Differentialgleichung höherer Ordnung bestimmen lässt, die den Zusammenhang zwischen messbaren Größen, oder aus messbaren Größen ableitbaren Größen, herstellt und zur Bildung einer Modellfehlerfunktion $\varepsilon$ geeignet ist. Dadurch erhöht sich lediglich die Ordnung des resultierenden linearen Gleichungssystems.

Aber selbst für nichtlineare Prozessmodelle existieren geeignete Optimierungsmethoden zur Minimierung der Verlustfunktion. Die Anwendbarkeit dieser Methode (Minimierung einer Verlustfunktion) ist also nicht durch die Struktur oder die Eigenschaften des Prozessmodells eingeschränkt.

Die so bestimmten Parameter des elektrischen Netzes können nun zur Abstimmung der Erdschlusslöschspule verwendet werden. Ein solches Verfahren zur Durchführung der Abstimmung der Erdschlusslöschspule wird beispielhaft entsprechend dem nachfolgend vorgestellten Algorithmus beschrieben:

1) Die Sternpunkt-Erdspannung Une wird kontinuierlich gemessen. Ändert sich der netzfrequente Anteil von $U_{ne}$ und übersteigt die Änderung der Sternpunkt-Erdspannung $U_{ne}$ in Betrag und/oder Phase entweder vordefinierte oder sich aus der kontinuierlichen Messung der Sternpunkt-Erdspannung ergebende Schwellen, so wird ein Injektionszyklus zusammen mit einem Verfahren zur Bestimmung der Parameter des Nullsystems des sternpunktkompensierten Netzes ausgelöst und bei Schritt 3) fortgesetzt. Als Injektionszyklus ist dabei im Wesentlichen das Einspeisen eines Injektionssignals mit einem, den Bereich von $f_{min}$ bis $f_{max}$ im Wesentlichen überdeckenden Frequenzspektrum, das Messen und Erfassen der während des Injektionsvorganges oder nach dem Abklingen des Injektionssignals zu bestimmenden Größen und gegebenenfalls der nachfolgenden Anwendung eines Verfahrens zur Bestimmung mindestens eines Parameters des Nullsystems zu verstehen.

2) Zusätzlich zur Auslösung durch die Änderung des netzfrequenten Anteiles der Sterpunkt-Erdspannung $U_{ne}$ wird in periodischen Zeitabständen ein Injektionszyklus zusammen mit einem Verfahren zur Bestimmung mindestens eines Parameters des Nullsystems des sternpunktkompensierten Netzes ausgelöst und bei Schritt 3) fortgesetzt.

3) Durchführung des Injektionszyklus zusammen mit einem Verfahren zur Bestimmung mindestens einem der wesentlichen Parameter des Nullsystems des Netzes, entweder im Zeitbereich oder im Frequenzbereich, z.B. wie oben beschrieben.

4) Berechnung der zur Einhaltung der Resonanzbedingung notwendigen Erdschlusslöschspuleninduktivität $L_{soll}$ als Funktion der ermittelten Parameter des Nullsystems des Netzes unter Berücksichtigung einer eventuell vom Anwender vorgegebenen Verstimmung.

5) Vergleich der berechneten Erdschlusslöschspuleninduktivität $L_{soll}$ mit der momentan gegebenen Erdschlusslöschspuleninduktivität $L_{ist}$. Liegt der Absolutwert der Differenz von ($L_{soll}$ -$L_{ist}$) unter einer vom Anwender vorgegebenen oder durch $L_{soll}$ und/oder $L_{ist}$ bestimmten Toleranzschwelle, so kann bei Schritt 1) bzw. Schritt 2) fortgefahren und auf eine, sich durch Änderung des netzfrequenten Anteiles der Sternpunkt-Erdspannung $U_{ne}$ oder durch Ablauf der periodischen Vorwahlzeit ergebende, Auslösung eines unter Schritt 3) beschriebenen Injektionsvorganges gewartet werden.

Liegt der Absolutwert der Differenz von ($L_{soll}$ -$L_{ist}$) über dieser vom Anwender vorgegebenen oder durch $L_{soll}$ und/oder $L_{ist}$ bestimmten Toleranzschwelle, so wird die Erdschlusslöschspule in hinlänglich bekannter Weise auf die durch $L_{soll}$ vorgegebene Induktivität abgestimmt. Dies geschieht z.B. bei sogenannten Tauchkernspulen durch Verstellung des Tauchkernes auf eine Position, die aufgrund einer hinterlegten Kennlinie ermittelt wird. Diese Kennlinie beschreibt den Zusammenhang der Spuleninduktivität als Funktion von der Tauchkernstellung. Bei in Stufen schaltbaren Erdschlusslöschspulen ist jene Kombination der Schalterstellungen zu wählen, bei der die, sich aus der Schalterstellung ergebende, Gesamtinduktivität der Erdschlusslöschspule der berechneten Induktivität $L_{soll}$ am nächsten kommt. Dabei sind gegebenenfalls Nebenbedingungen zu beachten. Beispielsweise kann gefordert sein, dass die durch eine Kombination von Schalterstellungen sich gegebene Gesamtinduktivität zwar $L_{soll}$ am nächsten sein soll, aber immer größer oder höchstens gleich $L_{soll}$ sein darf, usw.

6) Nach dem Abstimmen der Erdschlusslöschspule auf $L_{soll}$ wird mit einem der Schritte 1) bis 3) fortgefahren.

Wird eine jener oben beschriebenen Methoden angewandt, bei der das Injektionssignal impulsartig eingebracht und als wichtiger Netzparameter die bei der momentan gegebenen Induktivität der Erdschlusslöschspule ermittelte Resonanzkreisfrequenz $\omega_{res}$ des Nullsystems des Netzes bestimmt wird, so kann auch die nachfolgende Methode zur Abstimmung der Erdschlusslöschspule vorteilhaft verwendet werden.

1) Entweder wird durch die Änderung des netzfrequenten Anteiles der Sternpunkt-Erdspannung $U_{ne}$ oder in periodischen Zeitabständen ein impulsartiger Injektionszyklus zusammen mit einem Verfahren zur Bestimmung der Parameter des Nullsystems des sternpunktkompensierten Netzes, im Wesentlichen zur Bestimmung der Resonanzkreisfrequenz $\omega_{res}$ ausgelöst und durchgeführt.

2) Liegt die ermittelte Resonanzkreisfrequenz $\omega_{res}$ in einem, um die gewünschte Resonanzkreisfrequenz $\omega_{soll}$ errichteten Toleranzfenster, so bleibt die Abstimmung der Erdschlusslöschspule unverändert und es wird wieder auf eine Auslösung des Injektionszyklus mit nachfolgender Bestimmung der Resonanzkreisfrequenz $\omega_{res}$ gewartet. Diese Auslösung erfolgt entweder durch die Änderung des netzfrequenten Anteiles der Sternpunkt-Erdspannung $U_{ne}$ oder durch Ablauf der vorgegebenen Zeitperiode.

Liegt die ermittelte Resonanzkreisfrequenz außerhalb einem, um die gewünschte Resonanzkreisfrequenz $\omega_{soll}$ errichteten Toleranzfenster, so ist die Erdschlusslöschspule in eine Richtung, abhängig davon, ob die ermittelte Resonanzkreisfrequenz $\omega_{res}$ größer oder kleiner als die gewünschte Resonanzkreisfrequenz $\omega_{soll}$ ist, zu verstimmen. Handelt es sich bei der verwendeten Erdschlusslöschspule um eine Tauchkernspule, so erfolgt deren Induktivitätsänderung während des Verstimmungsvorganges so langsam, dass der oben beschriebene Injektionsvorgang mit nachfolgender Bestimmung der Resonanzkreisfrequenz $\omega_{res}$ während des Verstimmungsvorganges solange wiederholt wird, bis die ermittelte Resonanzkreisfrequenz $\omega_{res}$ im Toleranzfenster liegt und der Verstimmungsvorgang somit abgeschlossen werden kann.

Die bestimmten Netzparameter oder Parameter eines oder mehrerer Leitungsabschnitte und/oder -abzeige können aber auch zur Erkennung und/oder Ortung von Erdfehlern oder zur Erkennung und/oder Lokalisierung von Schalthandlungen im Netz verwendet werden. Ein solches Verfahren wird in der WO 2004/003578 A1 des Anmelders beschrieben. Mit dem darin offenbarten Verfahren kann ein fehlerhafter Leitungsabschnitt oder Leitungsabzweig sehr einfach ermittelt werden, wie nachfolgend kurz umrissen. Springt nämlich der Realteil der Leitungsabzweignulladmittanz $Y(n) = g + C \cdot s$ plötzlich über eine vorwählbare Schwelle oder überschreitet die Differenz vom aktuellen Realteil und dem Wert vergangener Realteile eine andere vorwählbare Schwelle, während der Imaginärteil weitestgehend konstant bleibt, so ist der Leitungsabschnitt bzw. Leitungsabzweig fehlerhaft. Ändert sich hingegen plötzlich der Imaginärteil der Nulladmittanz, also überschreitet z.B. der Absolutbetrag der Differenz vom aktuellen Imaginärteil und von vergangener Imaginärteile der Abschnittsnulladmittanz eine gewisse vorwählbare Schwelle für eine vordefinierte Zeit, während der Realteil weitgehend konstant bleibt, so hat im überwachten Leitungsabschnitt bzw. -abzweig eine Zu- oder Abschaltung von einem oder mehreren Leitungsteilen stattgefunden.

Das nicht netzfrequente Injektionssignal kann in unterschiedlicher Weise in das Nullsystem des Netzes eingebracht werden.

Als erste Möglichkeit bietet sich an, das Injektionssignal in Form einer, mit der Erdschlusslöschspule in Serie geschalteten, Spannungsquelle einzubringen. Dabei wird der aus der Serienschaltung dieser Spannungsquelle und der Erdschlusslöschspule sich ergebende Zweipol einerseits mit dem Sternpunkt des Transformators oder mit dem Sternpunktanschluss eines Sternpunktbildners und andererseits mit Erde verbunden. Natürlich kann dieses Injektionssignal auch über einen einphasigen Transformator eingebracht werden, wobei dabei die erwähnte Spannungsquelle durch die Sekundärseite dieses Transformators zu ersetzen ist und eine Injektionsspannungsquelle mit der Primärseite dieses Transformators verbunden ist.

Als weitere Möglichkeit bietet sich die Einbringung des Injektionssignals in Form einer, zur Erdschlusslöschspule parallelen, Stromquelle an. Dies kann einerseits durch Einbringen eines Injektionsstromes in die Sekundärseite eines Einphasentransformators erfolgen, dessen Primärseite zur Erdschlusslöschspule parallel geschaltet ist oder andererseits über eine eventuell vorhandene Hilfswicklung der Erdschlusslöschspule direkt oder ebenfalls über einen Transformator erfolgen.

Es sei jedoch erwähnt, dass es natürlich vielfältige Möglichkeiten gibt, das Injektionssignal in das Nullsystem des Netzes einzubringen und alle diese Methoden für das nachfolgend dargelegte Verfahren als brauchbar anzusehen sind.

Wenn man bedenkt, dass ein aus der Serienschaltung einer Spannungsquelle mit einer Impedanz bestehender Zweipol sich immer durch einen Zweipol ersetzen lässt, der aus einer Stromquelle parallel zu dieser Impedanz besteht, wird erkennbar, dass unabhängig von der Art der Einbringung des Injektionssignals eine Ersatzschaltung, also ein Injektionsmodell, bestimmt werden kann, durch das die funktionalen Zusammenhänge zwischen einem messbaren äußeren Injektionssignal in Form einer Spannungs- oder Stromquelle und dem modellhaften Injektionsstrom $i_{inj}(t)$ nach

**EP 1 693 679 B1**

Fig.3 herstellbar sind. Diese modellhafte Injektionsstromquelle $i_{inj}(t)$ bildet parallel mit der Spulenimpedanz $X_n$ den Zweipol der Erdschlusslöschspule und entzieht sich aufgrund der Parallelschaltung mit $X_n$ somit der direkten Messung.

Das Injektionsfrequenzspektrum kann natürlich ebenfalls auf verschiedenste Arten erzeugt werden.

Eine Möglichkeit, die aber nicht beansprucht wird, besteht darin, das Frequenzspektrum dadurch abzudecken, indem durch kontinuierliches oder diskretes Verändern der Frequenz des Injektionssignals (z.B. eines Sinussignals) das Frequenzspektrum von $f_{min}$ bis $f_{max}$, vorzugsweise in einem vorgegebenen Zeitraum von einigen Sekunden, generiert wird. Die untere Frequenz $f_{min}$ und die obere Frequenz $f_{max}$ des Frequenzspektrums des Injektionssignals kann durch den Anwender vorteilhaft so gewählt werden, dass für alle möglichen Netztopologien bzw. Schaltzustände des Netzes sowie dem Stellbereich der Löschspule und eventuell im Netz vorhandener Zusatzspulen die sich aus der Resonanzkreisfrequenz $\omega_{res}$ ergebenden Resonanzfrequenz $f_{res}$ bezüglich des Nullsystems des Netzes immer im Intervall $f_{min}$ bis $f_{max}$ enthalten ist. Bei einer diskreten Erhöhung ist es weiters wünschenswert, dass die diskreten Schritte eng genug gewählt werden, um sicher eine Frequenz im Frequenzspektrum enthalten zu haben, die nahe genug an der Resonanzfrequenz $\omega_{res}$ liegt, um eine Anregung mit zumindest annähernd der Resonanzfrequenz $\omega_{res}$ und damit durch die Anregung bei Resonanzfrequenz $\omega_{res}$ große Signalamplituden sicher zu stellen.

Natürlich ist es gemäß der beanspruchten Ausführungsvariante auch möglich, die gewünschten Spektralanteile des Injektionsspektrums nicht sequentiell, sondern durch nicht sinusförmige, beispielsweise impulsartige, Injektionssignale gleichzeitig ins Nullsystem des Gesamtnetzes einzubringen. Dazu sollte die Signalform des Injektionssignals so gewählt werden, dass dessen Fouriertransformation weitgehend von Null verschiedene Spektralanteile im Frequenzbereich zwischen den oben definierten Grenzfrequenzen $f_{min}$ und $f_{max}$ beinhaltet, also keine Lücken im Frequenzspektrum enthalten sind. Damit kann ebenfalls sichergestellt werden, dass die Resonanzfrequenz des Nullsystems des Gesamtnetzes vorteilhaft im Injektionsspektrum enthalten ist. Eine mögliche Umsetzung könnte z.B. mittels eines Kondensators erfolgen, der aufgeladen und anschließend über einen geeignet dimensionierten Widerstand entladen wird, wodurch ein impulsartiges Signal erzeugt wird. Der, in der Praxis natürlich nur annähernd erreichbare, Idealfall wäre ein Dirac-Impuls, da dessen Frequenzspektrum bekannter Weise alle Frequenzen gleichmäßig beinhaltet.

Im gewünschten Frequenzbereich zwischen $f_{min}$ bis $f_{max}$, also beispielsweise zwischen 15Hz und 150Hz, sind natürlich unendlich viele Frequenzen enthalten. In der Praxis wird es unmöglich sein, ein Signal zu erzeugen, dass alle Frequenzen dieses Bereichs gleichmäßig abdeckt. Vielmehr wird es so sein, dass ein Injektionssignal gewählt wird, dessen Fouriertransformierte ein möglichst gleichmäßiges Frequenzspektrum und möglichst keine Frequenzen mit Spektralanteil gleich Null beinhaltet. Bei einem diskreten Frequenzspektrum kann dies durch die Wahl ausreichend kleiner diskreter Schritte sichergestellt werden. Beispielsweise kann der Bereich von $f_{min}$ bis $f_{max}$, z.B. von 15Hz bis 150Hz, mit Frequenzinkrementen von 1 Hz durchlaufen werden, wodurch sich für den beispielhaft angegebenen Frequenzbereich 136 diskrete Frequenzen ergeben würden. Wichtig ist nur, dass die durch die Diskretisierung entstehenden Frequenzlücken so klein sind, dass mit Sicherheit bei einer diskreten Frequenz eine Anregung mit zumindest annähernd Resonanzfrequenz erfolgt.

Selbstverständlich liefern auch Mischformen, die aber nicht beansprucht sind, des ersten und zweiten beschriebenen Injektionsverfahrens zufrieden stellende Ergebnisse. Entscheidend ist dabei nur, dass die Fouriertransformierte des Injektionssignales, vorzugsweise über die gesamte Injektionszeit betrachtet, ein das Frequenzintervall $f_{min}$ bis $f_{max}$ weitgehend überdeckendes Frequenzspektrum liefert.

**Patentansprüche**

1. Verfahren zur Bestimmung mindestens eines Parameters des Nullsystems eines elektrischen Versorgungsnetzes, vorzugsweise mit induktiv oder über ohmschen Widerstand geerdetem oder isoliertem Netzsternpunkt, und/oder eines Parameters des Nullsystems eines Leitungsabschnittes bzw. Leitungsabzweiges des elektrischen Versorgungsnetzes, insbesondere die Nulladmittanz $Y_0$ bzw. Y, die Phasensumme der Leitwerte der ohmschen Ableitungen $G_0$ bzw. g, die Phasensumme der Ableitkapazitäten $C_0$ bzw. C und/oder die Resonanzkreisfrequenz $\omega_{res}$ des Nullsystems des Versorgungsnetzes, wobei in den Netzsternpunkt oder in das Nullsystem des elektrischen Versorgungsnetzes zumindest zeitweise ein Injektionssignal eingespeist wird und mit dem Injektionssignal ein Frequenzspektrum eingespeist wird, wobei das Frequenzspektrum des Injektionssignals den Bereich zwischen einer wählbaren minimalen Frequenz $f_{min}$ und einer wählbaren maximalen Frequenz $f_{max}$ im Wesentlichen lückenlos abdeckt und im Frequenzspektrum die Resonanzfrequenz $\omega_{res}$ des Nullsystems des elektrischen Versorgungsnetzes enthalten ist und dass des zumindest eine Parameter aus einem das gesamte Frequenzspektrum berücksichtigenden funktionalen Zusammenhang von einer der zwei Größen Nullstrom $i_0$ und Verlagerungsspannung $U_{ne}$ bezüglich des gesamten eingespeisten Frequenzspektrums durch ein Verfahren im Zeitbereich oder Frequenzbereich ermittelt wird, **dadurch gekennzeichnet, dass** das Injektionssignal $i_{inj}$ impulsartig eingebracht wird und ein Zeitpunkt $t_1$ festgelegt wird, ab dem das Injektionssignal $i_{inj}$ bereits Null, bzw. nahezu Null, ist und die zu den Zeitpunkten $t>t_1$ ermittelten Messwerte der Verlagerungsspannung $U_{ne}$ oder des Nullstromes $i_0$ ausgewertet werden.

2. Verfahren nach Anspruch 1, **dadurch gekennzeichnet, dass** der Parameter aus einem funktionalen Zusammenhang von Nullstrom $i_0$ und Verlagerungsspannung $U_{ne}$ ermittelt wird.

3. Verfahren nach Anspruch 1 oder 2, **dadurch gekennzeichnet, dass** die netzfrequenten Signalanteile und Signalanteile mit Frequenzen, die einem ganzzahlig ungeradzahligem Vielfachen der Netzfrequenz entsprechen, aus dem Frequenzspektrum der gemessenen Größen herausgefiltert werden oder durch Subtraktion der vor dem Start des Injektionsvorganges als Funktion der Zeit gemessenen und bezüglich der Netzperiode für die Zeiten nach dem Injektionsvorgang periodisch fortgesetzten Größen von den gemessenen Größen aus diesen Größen entfernt werden.

4. Verfahren nach einem der Ansprüche 1 bis 3, **dadurch gekennzeichnet, dass** die Parameter mittels eines Parameterschätzverfahrens ermittelt werden.

5. Verfahren nach einem der Ansprüche 1 bis 4, **dadurch gekennzeichnet, dass** das elektrische Versorgungsnetz und/oder ein Leitungsabschnitt bzw. Leitungsabzweig durch ein mathematisches Modell beschrieben wird, bei dem die Modellausgangsgrößen $A_{Mod}$ als Funktion der messbaren Eingangsgrößen E und der Parameter beschrieben werden.

6. Verfahren nach Anspruch 5, **dadurch gekennzeichnet, dass** eine Modellfehlerfunktion $\varepsilon$ als Differenz aus gemessenen Ausgangsgrößen $A_P$ und Modellausgangsgrößen $A_{Mod}$ und daraus eine Verlustfunktion V, beispielsweise in Form der Summe der Quadrate der Modellfehlerfunktion $\varepsilon$ über den Beobachtungszeitraum, ermittelt wird, die zur Bestimmung der Parameter derart optimiert wird, dass die Verlustfunktion V minimal wird.

7. Verfahren nach einem der Ansprüche 1 bis 6, **dadurch gekennzeichnet, dass** die gemessenen Signale Nullstrom $i_0(t)$ und/oder Verlagerungsspannung $U_{ne}(t)$ und/oder Injektionssignal $I_{inj}(t)$ abgetastet und digitalisiert und gegebenenfalls deren netzfrequente Signalanteile und gegebenenfalls jene Signalanteile mit Frequenzen, die einem ganzzahlig ungeradzahligem Vielfachen der Netzfrequenz entsprechen, entfernt werden und die daraus entstehenden Signalwertefolgen $i_0(n)$ und/oder $U_{ne}(n)$ und/oder $I_{inj}(n)$ gespeichert werden.

8. Verfahren nach Anspruch 7, **dadurch gekennzeichnet, dass** aus den Signalwertefolgen $i_0(n)$ und/oder $U_{ne}(n)$ und/oder $I_{inj}(n)$, oder äquivalent aus deren Zeitintegralen beliebiger Ordnung oder deren Ableitungen bezüglich der Zeit beliebiger Ordnung, eine Modellfehlerfunktion $\varepsilon(n)$ als

$$f(n) - f_1(n) \cdot x_1 - f_2(n) \cdot x_2 - f_3(n) \cdot x_3 = \varepsilon(n) \quad \forall\, n \in \{0,1,2,...,N\},$$

mit $f(n)$, $f_1(n)$, $f_2(n)$ und $f_3(n)$ als Signalwertefolge der Messwerte oder deren äquivalenten Größen bezüglich der Zeit von Nullstrom $i_0(t)$ und/oder Verlagerungsspannung $U_{ne}(t)$ und/oder Injektionssignal $I_{inj}(t)$, Signalwertefolge der ersten Ableitung bezüglich der Zeit oder deren äquivalenten Größen der Messwerte Nullstrom $i_0(t)$ und/oder Verlagerungsspannung $U_{ne}(t)$ und/oder Injektionssignal $I_{inj}(t)$, Signalwertefolge des Integrals bezüglich der Zeit oder deren äquivalenten Größen der Messwerte Nullstrom $i_0(t)$ und/oder Verlagerungsspannung $U_{ne}(t)$ und/oder Injektionssignal $I_{inj}(t)$ und $x_1$, $x_2$ und $x_3$ als Parameter des elektrischen Versorgungsnetzes oder Leitungsabschnittes bzw. Leitungsabzweiges davon, gebildet wird.

9. Verfahren nach Anspruch 8, **dadurch gekennzeichnet, dass** ein lineares Gleichungssystem $\underline{C} \cdot \underline{x} = \underline{b}$ gebildet wird

mit einer Matrix $\underline{C}$ mit Elementen $c_{kj} = \sum_{n=0}^{N} f_k(n) \cdot f_j(n)$, $\forall\, k, j \in \{1,2,3\}$, einem Vektor $\underline{b}$ mit Elementen

$b_k = \sum_{n=0}^{N} f(n) \cdot f_k(n)$, $\forall\, k \in \{1,2,3\}$ und einem die gesuchten Parameter enthaltenden Lösungsvektor $\underline{x}$, das mit

hinlänglich bekannten Methoden zur Lösung von linearen Gleichungssystemen gelöst wird.

10. Verfahren nach Anspruch 1, **dadurch gekennzeichnet, dass** aus der für die Zeitpunkte $t \geq t_1$ ermittelten Signalwertefolge $U_{ne}(n)$ oder $i_0(n)$ der Messwerte der Verlagerungsspannung $U_{ne}(t)$ oder des Nullstromes $i_0(t)$, oder äquivalent

aus deren zeitlichen Integralen beliebiger Ordnung oder deren Ableitungen bezüglich der Zeit beliebiger Ordnung, eine Modellfehlerfunktion $\varepsilon(n)$ als

$$f(n) - f_1(n) \cdot x_1 - f_2(n) \cdot x_2 = \varepsilon(n) \quad \forall\, n \in \{1,2,...,N\},$$

mit $f(n)$ als Signalwertefolge der Differenz der ersten Ableitungen bezüglich der Zeit des Messwerts der Verlagerungsspannung $U_{ne}(t_1)$ oder des Nullstromes $i_0(t_1)$ oder deren äquivalenter Größen zum Zeitpunkt $t_1$ des ersten Samples minus der ersten Ableitung bezüglich der Zeit des Messwerts der Verlagerungsspannung $U_{ne}(t)$ oder des Nullstromes $i_0(t)$ oder deren äquivalenter Größen zum Zeitpunkt $t$ des $(n)$-ten Samples, $f_1(n)$ als Signalwertefolge der Differenz des Messwerts der Verlagerungsspannung $U_{ne}(t)$ oder des Nullstromes $i_0(t)$ oder deren äquivalenter Größen zum Zeitpunkt $t$ des $(n)$-ten Samples minus dem Messwert der Verlagerungsspannung $U_{ne}(t_1)$ oder des Nullstromes $i_0(t_1)$ oder deren äquivalenter Größen zum Zeitpunkt $t_1$ des ersten Samples und $f_2(n)$ als Signalwertefolge des Integrals bezüglich der Zeit des Messwerts der Verlagerungsspannung $U_{ne}(t)$ oder des Nullstromes $i_0(t)$ oder deren äquivalenter Größen für die Zeit von $t_1$ bis $t$, also vom ersten bis zum $(n)$-ten Sample, und $x_1$ und $x_2$ als Parameter des elektrischen Versorgungsnetzes, gebildet wird.

**11.** Verfahren nach Anspruch 10, **dadurch gekennzeichnet, dass** ein lineares Gleichungssystem $\underline{C} \cdot \underline{x} = \underline{b}$ gebildet wird mit einer Matrix $\underline{C}$ mit Elementen $c_{kj} = \sum\limits_{n=1}^{N} f_k(n) \cdot f_j(n), \quad \forall\, k, j \in \{1,2\}$, einem Vektor $\underline{b}$ mit Elementen

$b_k = \sum\limits_{n=1}^{N} f(n) \cdot f_k(n), \;\forall\, k \in \{1,2\}$ und einem die gesuchten Parameter, insbesondere die Resonanzkreisfrequenz $\omega_{res}$ des Nullsystems des Versorgungsnetzes, enthaltenden Lösungsvektor $\underline{x}$, das mit hinlänglich bekannten Methoden zur Lösung linearer Gleichungssysteme gelöst wird.

**12.** Verfahren nach einem der Ansprüche 1 bis 11, **dadurch gekennzeichnet, dass** die bestimmten Parameter des Nullsystems des elektrischen Versorgungsnetzes bzw. eines Leitungsabschnittes bzw. -abzweigs, insbesondere $Y_0$, $Y$, $G$, $g$, $C_0$, $C$ und/oder $\omega_{res}$, zur Erkennung und Ortung von Erdfehlern, Erkennung und Lokalisierung von Schalthandlungen im Versorgungsnetz und/oder zur Abstimmung einer Erdschlusslöschspule verwendet werden.

**13.** Verfahren nach Anspruch 12, **dadurch gekennzeichnet, dass** ein Erdfehler erkannt und gegebenenfalls angezeigt wird, wenn der Realteil und/oder die Realteiländerung der Nulladmittanz $Y$ des Versorgungsnetzes oder eines Leitungsabschnittes bzw. -abzweiges für eine vorgegebene Zeitspanne eine vorgegebene Fehlerschwelle überschreitet.

**14.** Verfahren nach Anspruch 13, **dadurch gekennzeichnet, dass** das Ende eines Fehlerzustandes erkannt und gegebenenfalls angezeigt wird, wenn für den Realteil und/oder die Realteiländerung die vorgegebene Fehlerschwelle für eine vorgegebene Zeitspanne wieder unterschritten wird.

**15.** Verfahren nach Anspruch 12, **dadurch gekennzeichnet, dass** eine Schalthandlung im Gesamtnetz oder innerhalb eines Leitungsabschnittes bzw. -abzweiges erkannt und gegebenenfalls angezeigt wird, wenn der Imaginärteil bzw. die Imaginärteiländerung der Nulladmittanz des Versorgungsnetzes $Y_0$ oder eines Leitungsabschnittes bzw. -abzweiges $Y(n)$ für eine vorgegebene Zeitspanne eine vorgegebene Fehlerschwelle überschreitet.

**16.** Verfahren nach Anspruch 12, **dadurch gekennzeichnet, dass** die zur Abstimmung notwendige Erdschlusslöschspuleninduktivität $L_{soll}$, gegebenenfalls unter Berücksichtigung eines vom Anwender vorgegebenen Verstimmungsgrads, als Funktion der ermittelten Parameter des Nullsystems des elektrischen Versorgungsnetzes zur Einhaltung der Resonanzbedingung ermittelt wird.

**17.** Verfahren nach Anspruch 16, **dadurch gekennzeichnet, dass** die bestimmte Erdschlusslöschspuleninduktivität $L_{soll}$ mit der momentan gegebenen Erdschlusslöschspuleninduktivität $L_{ist}$ verglichen wird und die Erdschlusslöschspule auf die bestimmte Erdschlusslöschspuleninduktivität $L_{soll}$ abgestimmt wird, falls die Abweichung der bestimmten Erdschlusslöschspuleninduktivität $L_{soll}$ von der momentan gegebenen Erdschlusslöschspuleninduktivität $L_{ist}$ eine vorgebbare Toleranzschwelle überschreitet.

**18.** Verfahren nach einem der Ansprüche 1, 10 oder 11 **dadurch gekennzeichnet, dass** die impulsartige Einbringung des Injektionssignals $i_{inj}$ und die Ermittlung der Resonanzkreisfrequenz $\omega_{res}$ des Nullsystems des Versorgungsnetzes als Parameter des Nullsystems des Versorgungsnetzes zum Erkennen der Notwendigkeit eines Abstimmvorgangs und/oder während des Abstimmvorgangs der Erdschlusslöschspule wiederholt wird, bis die Resonanzkreisfrequenz $\omega_{res}$ einen vorgebbaren Wert annimmt.

**Claims**

**1.** A method for determining at least one parameter of the zero sequence system of an electrical supply network, preferably with network star point which is inductively earthed or earthed via ohmic resistance or insulated, and/or a parameter of the zero sequence system of a line section or line branch of the electrical supply network, in particular the zero sequence I admittance $Y_0$ and Y respectively, the phase sum of the conductance values of the ohmic leakages $G_0$ and g respectively, the phase sum of the leakage capacitances $C_0$ and C respectively, and/or the resonant circuit frequency $\omega_{res}$ of the zero sequence system of the supply network, wherein an injection signal is fed for at least some of the time into the network star point or into the zero sequence system of the electrical supply network and a frequency spectrum is fed in with the injection signal, wherein the frequency spectrum of the injection signal covers the range between a selectable minimum frequency $f_{min}$ and a selectable maximum frequency $f_{max}$ substantially without gaps and the resonant frequency $\omega_{res}$ of the zero sequence system of the electrical supply network is contained in the frequency spectrum, and that at least one parameter is determined from a functional relationship, which takes into account the whole frequency spectrum, of one of the two quantities zero sequence current $i_0$ and residual voltage $U_{ne}$ with regard to the overall fed-in frequency spectrum by means of a method in the time domain or frequency domain, **characterized in that** the injection signal $I_{inj}$ is introduced in the form of a pulse and a time $t_1$ from which the injection signal $i_{inj}$ is already zero or almost zero is defined and the measured values of the residual voltage $U_{ne}$ or of the zero sequence current $i_0$ determined at the times $t>t_1$ are evaluated.

**2.** The method as claimed in claim 1, **characterized in that** the parameter is determined from a functional relationship of zero sequence current $i_0$ and residual voltage $U_{ne}$.

**3.** The method as claimed in claim 1 or 2, **characterized in that** the networkfrequency signal content and signal content with frequencies which correspond to an odd integral multiple of the network frequency are filtered out of the frequency spectrum of the measured quantities or are removed from these quantities by subtracting from these quantities the quantities measured as a function of time before the start of the injection process and periodically continued with regard to the network period for the times after the injection process.

**4.** The method as claimed in one of claims 1 to 3, **characterized in that** the parameters are determined by means of a parameter estimating method.

**5.** The method as claimed in one of claims 1 to 4, **characterized in that** the electrical supply network and/or a line section or line branch is described by a mathematical model in which the model output quantities $A_{Mod}$ are described as a function of the measurable input quantities E and the parameters.

**6.** The method as claimed in claim 5, **characterized in that** a model error function $\varepsilon$ is determined as the difference between measured output quantities $A_p$ and model output quantities $A_{mod}$, and a loss function V, for example in the form of the sum of the squares of the model error function $\varepsilon$, is determined over the observation period, which is optimized for determining the parameters in such a way that the loss function V becomes minimal.

**7.** The method as claimed in one of claims 1 to 6, **characterized in that** the measured signals zero sequence current $i_0(t)$ and/or residual voltage $U_{ne}(t)$ and/or injection signal $I_{inj}(t)$ are sampled and digitized and, if appropriate, their network-frequency signal content and, if appropriate, that signal content with frequencies which correspond to an odd integral multiple of the network frequency are removed and the resulting signal value sequences $i_0(n)$ and/or $U_{ne}(n)$ are stored.

**8.** The method as claimed in claim 7, **characterized in that**, from the signal value sequences $i_0(n)$ and/or $U_{ne}(n)$ and/or $I_{inj}(n)$, or equally from their time integrals of any order or their derivatives with respect to time of any order, a model error function $\varepsilon(n)$ is formed as

$$f(n) - f_1(n) \cdot x_1 - f_2(n) \cdot x_2 - f_3(n) \cdot x_3 = \varepsilon(n) \quad \forall\, n \in \{1,2,\dots,N\}$$

where $f(n)$, $f_1(n)$, $f_2(n)$ and $f_3(n)$ are signal value sequences of the measured values or their equivalent quantities with respect to time of zero sequence current $i_0(t)$ and/or residual voltage $U_{ne}(t)$ and/or injection signal $I_{inj}(t)$, signal value sequences of the first derivative with respect to time or their equivalent quantities of the measured values zero sequence current $i_0(t)$ and/or residual voltage $U_{ne}(t)$ and/or injection signal $I_{inj}(t)$, signal value sequences of the integral with respect to time or their equivalent quantities of the measured values zero sequence current $i_0(t)$ and/or residual voltage $U_{ne}(t)$ and/or injection signal $I_{inj}(t)$, and $x_1$, $x_2$ and $x_3$ are parameters of the electrical supply network or of the line section or of the line branch thereof respectively.

9. The method as claimed in claim 8, **characterized in that** a linear equation system $\underline{C} \cdot \underline{x} = \underline{b}$ is formed with a matrix $\underline{C}$ with elements $c_{kj} = \sum_{n=0}^{N} f_k(n) \cdot f_j(n)$, $\forall\, k,\ j\ \in\ \{1,2,3\}$, a vector $\underline{b}$ with elements $b_k = \sum_{n=0}^{N} f(n) \cdot f_k(n)$, $\forall\, k \in \{1,2,3\}$, and a solution vector $\underline{x}$ which contains the parameters sought and which is solved using methods for solving linear equation systems which are sufficiently well known.

10. The method as claimed in claim 1, **characterized in that**, from the signal value sequences $U_{ne}(n)$ or $i_0(n)$ of the measured values of the residual voltage $U_{ne}(t)$ or of the zero sequence current $i_0(t)$ determined for the times $t \leq t_1$ or equally from their time integrals of any order or their derivatives with respect to time of any order, a model error function $\varepsilon(n)$ is formed as

$$f(n) - f_1(n) \cdot x_1 - f_2(n) \cdot x_2 = \varepsilon(n) \quad \forall\, n \in \{1,2,\dots,N\},$$

where $f(n)$ is the signal value sequence of the difference of the first derivative with respect to time of the measured value of the residual voltage $U_{ne}(t_1)$ or of the zero sequence current $i_0(t_1)$ or of their equivalent quantities at time $t_1$ of the first sample minus the first derivative with respect to time of the measured value of the residual voltage $U_{ne}(t)$ or of the zero sequence current $i_0(t)$ or of their equivalent quantities at time $t$ of the nth sample, $f_1(n)$ is the signal value sequence of the difference of the measured value of the residual voltage $U_{ne}(t)$ or of the zero sequence current $i_0(t)$ or of their equivalent quantities at time $t$ of the nth sample minus the measured value of the residual voltage $U_{ne}(t_1)$ or of the zero sequence current $i_0(t_1)$ or of their equivalent quantities at time $t_1$ of the first sample, and $f_2(n)$ is the signal value sequence of the integral with respect to time of the measured value of the residual voltage $U_{ne}(t)$ or of the zero sequence current $i_0(t)$ or of their equivalent quantities for the time from $t_1$ to $t$, that is to say from the first to the nth sample, and $x_1$ and $x_2$ are parameters of the electrical supply network.

11. The method as claimed in claim 10, **characterized in that** a linear equation system $\underline{C} \cdot \underline{x} = \underline{b}$ is formed with a matrix $\underline{C}$ with elements $c_{kj} = \sum_{n=1}^{N} f_k(n) \cdot f_j(n)$, $\forall\, k,\ j\ \in\ \{1,2\}$, a vector $\underline{b}$ with elements $b_k = \sum_{n=1}^{N} f(n) \cdot f_k(n)$, $\forall\, k \in \{1,2\}$, and a solution vector $\underline{x}$ which contains the parameters sought, in particular the resonant circuit frequency $\omega_{res}$ of the zero sequence system of the supply network, and which is solved using methods for solving linear equation systems which are sufficiently well known.

12. The method as claimed in one of claims 1 to 11, **characterized in that** the determined parameters of the zero sequence system of the electrical supply network or of a line section or branch, in particular $Y_0$, $Y$, $G$, $g$, $C_0$, $C$ and/or $\omega_{res}$, are used for the detection and location of earth faults, detection and localization of switching operations in the supply network and/or for tuning an earth fault suppression coil.

13. The method as claimed in claim 12, **characterized in that** an earth fault is detected and, if appropriate, indicated when the real part and/or the change in the real part of the zero sequence admittance $Y$ of the supply network or of a line section or branch exceeds a specified fault threshold for a specified time.

**14.** The method as claimed in claim 13, **characterized in that** the end of the fault situation is detected and, if appropriate, indicated when the real part and/or the change in the real part falls below the specified fault threshold once more for a specified time.

**15.** The method as claimed in claim 12, **characterized in that** a switching operation in the overall network or within a line section or branch is detected and, if appropriate, indicated when the imaginary part or the change in the imaginary part of the zero sequence admittance of the supply network $Y_0$ or of a line section or branch Y(n) exceeds a specified fault threshold for a specified time.

**16.** The method as claimed in claim 12, **characterized in that** the inductance $L_{soll}$ of the earth fault suppression coil required for tuning is determined as a function of the determined parameters of the zero sequence system of the electrical supply network for maintaining the resonant condition, if appropriate taking into account a degree of detuning specified by the user.

**17.** The method as claimed in claim 16, **characterized in that** the determined inductance $L_{soll}$ of the earth fault suppression coil is compared with the instantaneous inductance $L_{ist}$ of the earth fault suppression coil and the earth fault suppression coil is tuned to the determined inductance $L_{soll}$ of the earth fault suppression coil if the deviation of the determined inductance $L_{soll}$ of the earth fault suppression coil from the instantaneous inductance $L_{ist}$ of the earth fault suppression coil exceeds a specifiable tolerance threshold.

**18.** The method as claimed in one of claims 1, 10 or 11, **characterized in that** the introduction of the injection signal $I_{inj}$ in the form of a pulse and the determination of the resonant circuit frequency $\omega_{res}$ of the zero sequence system of the supply network as a parameter of the zero sequence system of the supply network is repeated in order to detect the need for a tuning process and/or during the tuning process of the earth fault suppression coil until the resonant circuit frequency $\omega_{res}$ assumes a specifiable value.

**Revendications**

**1.** Procédé de détermination d'au moins un paramètre du système de neutre d'un réseau de distribution électrique, comportant de préférence un point étoile de réseau mis à la terre par une inductance ou par une résistance ohmique, ou isolé, et/ou d'un paramètre du système de neutre d'une section de ligne ou d'un embranchement de ligne du réseau de distribution électrique, en particulier de l'admittance de neutre $Y_0$ ou Y, la somme des phases des conductances des dérivées ohmiques $G_0$ ou g, la somme des phases des capacités de dérivation $C_0$ ou C respectivement et/ou la fréquence de circuit résonant $\omega_{res}$ du système de neutre du réseau de distribution, dans lequel un signal d'injection ou, avec le signal d'injection, un spectre de fréquences, est ou sont injectés au moins temporairement dans le point étoile du réseau ou dans le système de neutre du réseau de distribution électrique, le spectre de fréquences du signal d'injection couvrant sensiblement sans discontinuité la plage entre une fréquence minimale $f_{min}$ pouvant être sélectionnée et une fréquence maximale $f_{max}$ pouvant être sélectionnée et la fréquence de résonance $\omega_{res}$ du système de neutre du réseau de distribution électrique étant contenue dans le spectre de fréquences, et l'au moins un paramètre étant déterminé par un procédé exécuté dans la plage de temps ou dans la plage de fréquences, sur la base d'une relation fonctionnelle, qui tient compte de l'ensemble du spectre de fréquences, entre l'une des deux grandeurs, le courant de neutre $i_0$ et la tension de décalage $U_{ne}$, et l'ensemble du spectre de fréquence injecté, **caractérisé en ce que** le signal d'injection $i_{inj}$ est introduit par impulsions et on fixe un instant $t_1$ à partir duquel le signal d'injection $i_{inj}$ est déjà zéro ou presque zéro et les valeurs de mesure de la tension de décalage $U_{ne}$ ou du courant de neutre $i_0$ déterminées aux instants $t>t_1$ sont évaluées.

**2.** Procédé selon la revendication 1, **caractérisé en ce que** le paramètre est déterminé sur la base d'une relation fonctionnelle entre le courant de neutre $i_0$ et la tension de décalage $U_{ne}$.

**3.** Procédé selon l'une des revendications 1 ou 2, **caractérisé en ce que** les parties de signal ayant la fréquence du réseau et les parties de signal ayant des fréquences qui correspondent à un multiple entier impair de la fréquence du réseau sont extraites par filtrage du spectre de fréquences des grandeurs mesurées ou sont éliminées de ces grandeurs en soustrayant des grandeurs mesurées les grandeurs qui ont été mesurées en fonction du temps avant le démarrage du processus d'injection et qui ont été prolongées périodiquement par rapport à la période du réseau pour les temps qui suivent le processus d'injection.

**4.** Procédé selon l'une des revendications 1 à 3, **caractérisé en ce que** les paramètres sont déterminés au moyen d'un procédé d'évaluation des paramètres.

**5.** Procédé selon l'une des revendications 1 à 4, **caractérisé en ce que** le réseau de distribution électrique et/ou une section de ligne ou un branchement de ligne est ou sont décrit(s) par un modèle mathématique dans lequel les grandeurs de sortie du modèle $A_{Mod}$ sont décrites sous la forme d'une fonction des grandeurs d'entrée mesurables E et des paramètres.

**6.** Procédé selon la revendication 5, **caractérisé en ce que** l'on détermine une fonction d'erreur de modèle $\varepsilon$ sous la forme d'une différence entre les grandeurs de sortie mesurées $A_P$ et les grandeurs de sortie de modèle $A_{Mod}$ et on détermine sur cette base une fonction de perte V, par exemple sous la forme de la somme des carrés de la fonction de défaut de modèle $\varepsilon$ sur l'espace de temps d'observation, fonction qui est optimisée pour établir les paramètres de manière que la fonction de perte V soit minimale.

**7.** Procédé selon l'une des revendications 1 à 6, **caractérisé en ce que** les signaux mesurés, le courant de neutre $i_0(t)$ et/ou la tension de décalage $U_{ne}(t)$ et/ou le signal d'injection $I_{inj}(t)$ sont analysés et numérisés et **en ce qu'**éventuellement, les parties de signaux ayant la fréquence du réseau et éventuellement les parties de signaux ayant des fréquences qui correspondent à un multiple entier impair de la fréquence du réseau sont éliminées et les suites de valeurs de signaux $I_0(n)$ et/ou $U_{ne}(n)$ et/ou $I_{inj}(n)$ qui en résultent sont mémorisées.

**8.** Procédé selon la revendication 7, **caractérisé en ce qu'**à partir des suites de valeurs de signaux $i_0(n)$ et/ou $U_{ne}(n)$ et/ou $I_{in}(n)$ ou, de façon équivalente, à partir de leurs intégrales par rapport au temps d'un ordre quelconque ou de leurs dérivées par rapport au temps d'un ordre quelconque, on forme une fonction d'erreur de modèle $\varepsilon(n)$ sous la forme

$$f(n) - f_1(n) \cdot x_1 - f_2(n) \cdot x_2 - f_3(n) \cdot x_3 = \varepsilon(n) \quad \forall n \in \{0, 1, 2, ..., N\},$$

où $f(n)$, $f_1(n)$, $f_2(n)$ et $f_3(n)$ sont des suites de valeurs de signaux des valeurs de mesure ou de leurs grandeurs équivalentes par rapport au temps du courant de neutre $i_0(t)$ et/ou de la tension de décalage $U_{ne}(t)$ et/ou du signal d'injection $I_{inj}(t)$, des suites de valeurs de signaux de la dérivée première par rapport au temps ou de leurs grandeurs équivalentes des valeurs de mesure du courant de neutre $i_0(t)$ et/ou de la tension de décalage $U_{ne}(T)$ et/ou du signal d'injection $I_{inj}(t)$, des suites de valeurs de signaux de l'intégrale par rapport au temps ou de grandeurs équivalentes des valeurs de mesure de courant de neutre et $1_0(T)$ et/ou de la tension de décalage $U_1(T)$ et/ou du signal d'injection $I_{inj}(t)$ et $x_1$, $x_2$ et $x_3$ sont des paramètres du réseau de distribution électrique ou de la section de ligne ou de l'embranchement de ligne de ce réseau.

**9.** Procédé selon la revendication 8, **caractérisé en ce que** l'on forme un système d'équations linéaires $\underline{\underline{C}} \cdot \underline{x} = \underline{b}$ ayant une matrice $\underline{\underline{C}}$ comportant les éléments $c_{kj} = \sum_{n=0}^{N} f_k(n) \cdot f_j(n) \quad \forall k, j \in \{1, 2, 3\}$, un vecteur $\underline{b}$ comprenant les éléments $b_k = \sum_{n=0}^{N} f(n) \cdot f_k(n), \ \forall k \in \{1, 2, 3\} \quad \forall k \in \{1, 2, 3\}$ et un vecteur de solution $\underline{x}$ contenant les paramètres recherchés, qui est résolu avec des méthodes de résolution des systèmes d'équations linéaires qui sont suffisamment connues.

**10.** Procédé selon la revendication 1, **caractérisé en ce qu'**à partir de la suite de valeurs de signal $U_{ne}(n)$ ou $i_0(n)$ déterminées pour les instants $t \geq t_1$, des valeurs de mesure de la tension de décalage $U_{ne}(t)$ ou du courant de zéro $i_0(t)$, ou équivalents tirés de leurs intégrales par rapport au temps d'un ordre quelconque ou de leurs dérivées par rapport au temps d'un ordre quelconque, on forme une fonction d'erreur de modèle $\varepsilon(n)$ sous la forme suivante

$$f(n) - f_1(n) \cdot x_1 - f_2(n) \cdot x_2 = \varepsilon(n) \quad \forall n \in \{1, 2, ..., N\},$$

où f(n) est une suite des valeurs de signaux de la différence des dérivées premières par rapport au temps de la valeur de mesure de la tension de décalage $U_{ne}(t_1)$ ou du courant de neutre $i_0(t_1)$ ou de leurs grandeurs équivalentes à l'instant $t_1$ du premier échantillon moins la dérivée première par rapport au temps de la valeur de mesure de la tension de décalage $U_{ne}(t)$ ou du courant de neutre $i_0(t)$ ou de leurs grandeurs équivalentes à l'instant t du (n)-ème échantillon, $f_1(n)$ sous la forme de suite de valeurs de signaux de la différence entre la valeur de mesure de la tension de décalage $U_{ne}(t)$ ou du courant de neutre $i_0(t)$ ou de leurs grandeurs équivalentes à l'instant t du (n)-ème échantillon et la valeur de mesure de la tension de décalage $U_{ne}(t_1)$ ou du courant de neutre $i_0(t1)$ ou de leurs grandeurs équivalentes à l'instant $t_1$ du premier échantillon et $f_2(n)$ sous la forme d'une suite de valeurs de signaux de l'intégrale par rapport au temps de la valeur de mesure de la tension de décalage $U_{ne}(t)$ ou du courant de neutre $i_0(t)$ ou de leurs grandeurs équivalentes pour le temps allant de $t_1$ à t, donc du premier échantillon au (n)-ème échantillon et $x_1$ et $x_2$ comme paramètres du réseau de distribution électrique.

11. Procédé selon la revendication 10, **caractérisé en ce que** l'on forme un système d'équations linéaires $\underline{\textbf{C}} \cdot \underline{\textbf{x}} = \underline{\textbf{b}}$ qui comprend une matrice $\underline{\textbf{C}}$ contenant des éléments $c_{kj} = \sum_{n=1}^{N} f_k(n) \cdot f_j(n) \quad \forall\, \textbf{\textit{k, j}} \in \{1,2\}$, un vecteur $\underline{b}$ présentant les éléments $b_k = \sum_{n=1}^{N} f(n) \cdot f_k(n), \ \forall\, k \in \{1,2\}$ et un vecteur de résolution $\underline{x}$ contenant les paramètres recherchés, en particulier la fréquence du circuit résonant $\omega_{res}$ du système de neutre du réseau de distribution, système qui est résolu avec des méthodes de résolution des systèmes d'équations linéaires qui sont suffisamment connues.

12. Procédé selon l'une des revendications 1 à 11, **caractérisé en ce que** les paramètres déterminés du système de neutre du réseau de distribution électrique, ou d'une section de ligne ou d'un embranchement de ligne, en particulier $Y_0$, Y, G, g, $C_0$, C et/ou $\omega_{res}$, sont utilisés pour la détection et la localisation de défauts de terre, la détection et la localisation de manipulations de commandes dans le réseau de distribution et/ou pour l'accord d'une bobine de soufflage de mise à la terre.

13. Procédé selon la revendication 12, **caractérisé en ce qu'**un défaut de terre est reconnu et éventuellement signalé lorsque la partie réelle et/ou la variation de la partie réelle de l'admittance de neutre Y du réseau de distribution ou d'une section ou d'un embranchement de ligne dépasse(nt) un seuil de défaut prédéterminé pendant un laps de temps prédéterminé.

14. Procédé selon la revendication 13, **caractérisé en ce que** la fin d'un état de défaut est détectée et éventuellement signalée lorsque, pour la partie réelle et/ou la variation de la partie réelle, on est de nouveau passé au-dessous du seuil de défaut prédéterminé pendant un laps de temps prédéterminé.

15. Procédé selon la revendication 12, **caractérisé en ce qu'**une manipulation de commande dans l'ensemble du réseau ou dans les limites d'une section de ligne ou d'un embranchement de ligne est détectée et éventuellement signalée lorsque la partie imaginaire ou la variation de partie imaginaire de l'admittance de neutre du réseau de distribution $Y_0$ ou d'une section ou d'un embranchement de ligne Y(n), dépasse un seuil de défaut prédéterminé pendant un laps de temps prédéterminé.

16. Procédé selon la revendication 12, **caractérisé en ce que** l'inductance $L_{soll}$ de la bobine de soufflage de mise à la terre qui est nécessaire pour l'accord est déterminée pour respecter la condition de résonance, éventuellement en tenant compte d'un degré de désaccord prédéterminé par l'utilisateur, en fonction du paramètre déterminé du système de neutre du réseau de distribution électrique.

17. Procédé selon la revendication 16, **caractérisé en ce que** l'inductance déterminée de la bobine de soufflage de mise à la terre $L_{soll}$ est comparée à l'inductance $L_{ist}$ de la bobine de soufflage donnée momentanément et la bobine de soufflage de mise à la terre est accordée sur l'inductance stipulée $L_{soll}$ de la bobine de soufflage de mise à la terre dans le cas où l'écart de l'inductance stipulée $L_{soll}$ de la bobine de soufflage de mise à la terre par rapport à l'inductance $L_{ist}$ constatée momentanément de la bobine de soufflage de mise à la terre dépasse un seuil de tolérance pouvant être prédéterminé.

18. Procédé selon l'une des revendications 1, 10 ou 11, **caractérisé en ce que** l'introduction par impulsions du signal d'injection $i_{inj}$ et la détermination de la fréquence du circuit résonant $\omega_{res}$ du système de neutre du réseau de distribution en tant que paramètre du système de neutre du réseau de distribution pour la détection de la nécessité d'un processus d'accord et/ou pendant le processus d'accord de la bobine d'extinction du défaut de terre sont répétées jusqu'à ce que la fréquence du circuit résonant $\omega_{res}$ prenne une valeur pouvant être prédéterminée.

Fig. 1

**Fig. 2**

Erdschluss-Löschspule
mit Injektions Einheit

Netz

**Fig. 3**

Prozessausgangsgrössen
$A_P(y_1, ... , y_n)$

Prozess

Eingangsgrössen E

$-$  Modellfehler $\varepsilon$  z.B. $V = \int_T \varepsilon^2 d\tau$  Verlustfunktion
$V(y_1, ... , y_n)$

$\oplus$

Mathem.
Modell

Modellausgangsgrössen
$A_{Mod}(y_1, ... , y_n)$

Optimale Parameter
$y_1, ... , y_n$  $\leftarrow$  Optimierung

Bestimmung d. Parameter
$y_1, ... , y_n$, sodass $V(y_1, ... , y_n)$
minimal wird.

## Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 235145 B1
- EP 595677 A1
- WO 2004003578 A1
- WO 0215355 A2
- US 5587662 A
- DE 10006443 A1